(19) Europäisches Patentamt / European Patent Office / Office européen des brevets

(11) **EP 1 713 014 B1**

(12) **EUROPÄISCHE PATENTSCHRIFT**

(45) Veröffentlichungstag und Bekanntmachung des Hinweises auf die Patenterteilung:
**11.03.2009 Patentblatt 2009/11**

(51) Int Cl.:
*G06F 17/50* *(2006.01)*

(21) Anmeldenummer: **06007248.5**

(22) Anmeldetag: **06.04.2006**

(54) **Verfahren zum Entwurf einer analogen Schaltung, mit Bestimmung von Großsignal-Parameter aus der Auswertung von Kleinsignal-Parameter auf mehreren Lastlinien**

Method to design an analog circuit, where a large signal parameter is determined based on the evaluation of small signal parameters on several load lines

Procédé pour le dessin d'un circuit analogique comportant la détermination d'un paramètre grand-signal à partir de l'évaluation de paramètres de bas signal sur plusieurs lignes de charge

(84) Benannte Vertragsstaaten:
**DE FR**

(30) Priorität: **11.04.2005 DE 102005016459**

(43) Veröffentlichungstag der Anmeldung:
**18.10.2006 Patentblatt 2006/42**

(73) Patentinhaber: **Bromberger, Christoph**
**74074 Heilbronn (DE)**

(72) Erfinder: **Bromberger, Christoph**
**74074 Heilbronn (DE)**

(74) Vertreter: **Müller, Wolf-Christian et al**
**Patentanwalt**
**Maaßstraße 32/1**
**69123 Heidelberg (DE)**

(56) Entgegenhaltungen:
**US-A- 5 528 509**

- **AGAR B T JR ET AL: "The IRIDIUM K-band MMIC chip set" MICROWAVE AND MILLIMETER-WAVE MONOLITHIC CIRCUITS SYMPOSIUM, 1995. DIGEST OF PAPERS., IEEE 1995 ORLANDO, FL, USA 15-16 MAY 1995, NEW YORK, NY, USA,IEEE, US, 15. Mai 1995 (1995-05-15), Seiten 21-24, XP010148498 ISBN: 0-7803-2590-7**
- **MOON-QUE LEE ET AL: "High-Efficiency Harmonic Loaded Oscillator with Low Bias Using a Nonlinear Design Approach" IEEE TRANSACTIONS ON MICROWAVE THEORY AND TECHNIQUES, IEEE SERVICE CENTER, PISCATAWAY, NJ, US, Bd. 47, Nr. 9, September 1999 (1999-09), Seiten 1670-1679, XP011037720 ISSN: 0018-9480**
- **QUACH T ET AL: "A High Efficiency Commercial Gaas Mesfet Power Amplifier for Pcm/cia Applications at 2.45 Ghz" GAAS IC SYMPOSIUM, 16. Oktober 1994 (1994-10-16), Seiten 179-182, XP010255318**

**Beschreibung**

Die vorliegende Erfindung betrifft ein computerimplementiertes Verfahren zum Entwurf einer Schaltung mit einem aktiven Bauelement, insbesondere in einem Hochfrequenzschaltkreis.

Nach dem Stand der Technik des Designs elektronischer Schaltkreise sind Wege der Dimensionierung elektronischer Bauelemente und der Festlegung geeigneter Arbeitspunkte für die elektronischen Bauelemente bekannt. Eine besondere Rolle spielen hierbei Methoden, die Schaltungs-Kenngrößen in der Reflektionsfaktor-Ebene, namentlich im passiven Teil der Reflektionsfaktor-Ebene, nachfolgend Smith-Chart genannt, darstellen, und zwar insbesondere in Form von Isohypsen. So werden beispielsweise im Eingangs- und im Ausgangs-Smith-Chart eines aktiven Bauelementes zu einem gegebenen Arbeitspunkt Linien als Ortskurven konstanter Leistungsverstärkung in Abhängigkeit von Ein- bzw. Ausgangsreflektionsfaktor eingezeichnet. Das Smith-Chart per se ist hierbei als Reflektionsfaktordiagramm zunächst eine Kleinsignal-Methode.

Wesentliche Kenngrößen für einen Leistungsverstärker sind die lineare Ausgangsleistung, nachfolgend quantifiziert durch den Kompressionspunkt, $P_{-1dB}$, die Effizienz der Leistungsverstärkung, im Folgenden bezeichnet als "PAE", sowie die Größe der Leistungsverstärkung, gemessen auf logarithmischer Skala, charakterisiert durch G (engl. gain).

So genannte Smith-Charts mit eingezeichneten Isohypsen beispielsweise eines konstanten Rolletschen k-Faktors erlauben einem Designer, zu dem betrachteten Arbeitspunkt des Bauelementes Aussagen hinsichtlich der Funktionalität treffen zu können. Die Erzeugung der Isohypsen erfolgt hierbei typischerweise automatisiert.

Der Stand der Design-Technik erlaubt zudem die automatische Generierung von isohyptischen Bereichen für Größen, welche sich im Ausgangskennlinienfeld aus den lokalen Schaltungseigenschaften herleiten lassen. Mit Hilfe des Postprozessors zum "Advanced Design System" ADS von Agilent beispielsweise lassen sich derartige Isohypsen automatisch generieren mit Befehlen wie contour(max_gain(S)).

Diese numerischen Berechnungen erfordern einen erheblichen Aufwand, um benötigte Eigenschaften des Verstärkers oder eines aktiven Bauelementes exakt zu bestimmen.

Aus der US 5,528,509 ist ein Verfahren zum Entwurf eine Hochfrequenzschaltkreises bekannt. Dabei werden S-Parameter eines Transistors in einer Mehrzahl von Arbeitspunkten gemessen mit einem vorläufigen Lastwiderstand. Die S-Parameter werden auf der Lastlinie bestimmt basierend auf der Leistungsverstärkung. Eingangs- und Ausgangs-Leistungs-Charakteristika werden erhalten um die optimale Last zu bestimmen. Danach werden mittels eines linearen Simulators Eingangs- und Ausgangsschaltungen entwickelt, so dass die optimale Last realisiert wird.

Aufgabe der vorliegenden Erfindung ist es, ein weiterentwickeltes automatisiertes Verfahren zur Unterstützung eines Designers anzugeben, das zum Entwurf einer Schaltung mit einem aktiven Bauelement, vorzugsweise eines Hochfrequenzschaltkreises, dient.

Diese Aufgabe wird durch das Verfahren mit den Merkmalen des Anspruchs 1 und durch die elektronische Datenverarbeitungsanlage mit den Merkmalen des Anspruchs 20 gelöst. Vorteilhafte Weiterbildungen der Erfindung sind Gegenstand von Unteransprüchen.

Demgemäß ist ein computerimplementiertes Verfahren zum Entwurf einer Schaltung mit einem aktiven Bauelement, das durch Bauelemente der Schaltung in einem Arbeitspunkt eingestellt ist, vorzugsweise für einen Hochfrequenzschaltkreis, vorgesehen. In diesem Verfahren wird

- eine Vielzahl (Gnm) von Lastlinien (G) des aktiven Bauelements näherungsweise ermittelt wird,

- ein Verlauf einer Kleinsignal-Kenngröße entlang einer jeden Lastlinie (G) näherungsweise bestimmt wird, wobei die Kleinsignal-Kenngröße eine Verstärkung oder ein S-Parameter oder eine Rauschzahl oder ein effektiver Eingangsreflektionsfaktor oder ein effektiver Ausgangsreflektionsfaktor oder ein effektiver Ausgangswiderstand oder ein Rolletscher Stabilitätsfaktor ist,

- ein Bereich (B) einer jeden Lastlinie (G) als eine Teilmenge der Lastlinie (G) bestimmt wird, wobei der Bereich (B) durch eine charakteristische, von der Kleinsignal-Kenngröße abhängende Eigenschaft ausgezeichnet ist, und

- zur Bestimmung des Arbeitspunktes des aktiven Bauelementes für eine optimale Großsignal-Kenngröße ein der Lastlinie (G) zugeordneter Wert einer Großsignal-Kenngröße aus dem Verlauf der Kleinsignal-Kenngröße innerhalb des Bereiches (B) näherungsweise ermittelt wird, wobei die Großsignal-Kenngröße eine Leistungsverstärkung oder ein Intermodulationsprodukt der Ordnung n oder eine harmonische Verzerrung n-ter Ordnung oder ein Klirrfaktor oder eine Effizienz der Leistungsverstärkung oder eine Rauschzahl oder ein Kompressionspunkt oder eine Kompressionsleistung oder eine Kompression der Leistungsverstärkung oder ein Durchschnitt der Kleinsignal-Kenngröße oder ein Integral der Kleinsignal-Kenngröße ist.

Zur näherungsweisen Bestimmung kann die Kleinsignal-Kenngröße beispielsweise abgeschätzt werden, indem ein mathematisches Näherungsverfahren genutzt wird. Die Lastlinien im Ausgangskennlinienfeld eines aktiven Elementes ist in den meisten technisch wichtigen Fällen eine in sich geschlossene Kurve (eine Ausnahme hiervon bilden lediglich so genannte chaotische Systeme). Eine solche Lastlinie kann beispielsweise ein endliches Gebiet des Ausgangskennlinienfeldes umschließen. Eine Lastlinie kann aber auch auf einen Geradenabschnitt kollabieren. In Analogie zum Verhalten eines ohmschen Widerstandes an einer Quelle mit reellem Innenwiderstand spricht man in diesem Fall von einer "Widerstandsgeraden", oder einer "(ohmschen) Lastgeraden". Während eine Kleinsignal-Kenngröße von einem genähert linearen Verhalten eines aktiven Bauelementes in einem Arbeitspunkt ausgeht, berücksichtigt eine Großsignal-Kenngröße zudem Nicht-Linearitäten, die durch die Übertragungscharakteristik des aktiven Bauelementes bedingt sind.

Gemäß einer vorteilhaften Ausgestaltung der Erfindung ist vorgesehen, dass zur Ermittlung der Vielzahl von Lastlinien eine erste Menge, enthaltend eine erste Anzahl von Stütz-Arbeitspunkten, gewählt und jedem Stütz-Arbeitspunkt eine Menge, enthaltend eine zweite Anzahl von Lastlinien, zugeordnet wird.

Zusätzlich oder alternativ zu einem Smith-Chart ermöglicht eine solche, von Ausgangskennlinienfeld ausgehende, Betrachtungsweise durch den engen, intuitiv erfassbaren Zusammenhang mit dem Verhalten eines Bauelementes oder Schaltkreises unter Großsignalaussteuerung eine vereinfachte Analyse.

In einer Weiterbildung des Verfahrens wird die Vielzahl von Lastlinien ermittelt, indem

- eine erste Menge von Stütz-Arbeitspunkten bestimmt wird,
- in jedem Stütz-Arbeitspunkt ein effektiver Ausgangswiderstand zu einer gegebenen Anpassbedingung am Eingang ermittelt wird,
- in jedem Stütz-Arbeitspunkt eine Geradensteigung ermittelt wird als ein Absolutquadrat der effektiven Ausgangsimpedanz, geteilt durch zweimal den Realteil der effektiven Ausgangsimpedanz, sowie eine Lastlinie als Gerade mit der ermittelten Geradensteigung durch den Stütz-Arbeitspunkt; "effektive Ausgangsimpedanz" bezeichnet hierbei die bei gegebener Eingangs-Anpassbedingung ausgangsseitig effektiv gesehene Ausgangsimpedanz.

Ferner wird jeder Lastlinie als Ausgangsimpedanz vorzugsweise das komplex Konjugierte der effektiven Ausgangsimpedanz zugeordnet.

Die Bewegung im Ausgangskennlinienfeld beispielsweise eines Kollektors eines Bipolartransistors in Basisschaltung wird bestimmt von einer Parallelschaltung der Ausgangsimpedanz des Bipolartransistors mit der Eingangsimpedanz der Last. Im Falle von ausgangsseitiger Leistungsanpassung erfolgt diese Bewegung, zumindest lokal, auf einer ohmschen Lastlinie mit der Geradensteigung. Diese Geradensteigung im Anfang der beschriebenen Weiterbildung des Verfahrens als Steigung der Lastlinien heranzuziehen, bringt die später aufzufindenden Bedingungen für einen optimierten Betrieb des Bauelementes oder Schaltkreises "in die Nähe" von Bedingungen für einen Betrieb mit maximaler Leistungsverstärkung.

In einer Weiterbildung des Verfahrens wird die Vielzahl von Lastlinien ermittelt, indem

- eine erste Menge von Stütz-Arbeitspunkten bestimmt wird,
- in jedem Stütz-Arbeitspunkt eine effektive Aus-gangsimpedanz zu einer gegebenen Anpassbedin-gung am Eingang ermittelt wird,
- in jedem Stütz-Arbeitspunkt eine Geradensteigung ermittelt wird als ein Absolutquadrat der effektiven Ausgangsimpedanz, geteilt durch zweimal den Realteil der effektiven Ausgangsimpedanz,
- in jedem Stütz-Arbeitspunkt eine variierte Geradensteigung ermittelt, sowie selbstkonsistent eine Lastimpedanz bestimmt wird, bei welcher Lastimpedanz eine Parallelschaltung von,

   a) erstens, der effektiven Ausgangsimpedanz des aktiven Bauelementes im Stütz-Arbeitspunkt bei gegebener Anpassbedingung am Eingang des aktiven Bauelementes, sowie
   b) zweitens, der Lastimpedanz, einen reellen Wert gleich der variierten Geradensteigung aufweist,

- sowie eine Lastlinie als Gerade mit der variierten Geradensteigung durch den Stütz-Arbeitspunkt gewählt wird;
- Ferner wird jeder Lastlinie als Ausgangsimpedanz die selbstkonsistent bestimmte Ausgangsimpedanz zugeordnet.

Bei der Optimierung des Bauelementverhaltens ist es häufig sinnvoll, in kontrollierter Weise von Betriebsbedingungen, die zu einer maximalen Leistungsverstärkung führen, abzuweichen, was von der vorliegenden Weiterbildung des Verfahrens in vorteilhafter Weise geleistet wird.

In einer Weiterbildung des Verfahrens erfolgt die Variation der Geradensteigung dergestalt, dass als variierte Geradensteigung diejenige Geradensteigung gewählt wird, bei welcher der Bereich die größte Ausdehnung hat.

In einer Weiterbildung des Verfahrens wird die erste Menge von Stütz-Arbeitspunkten gewählt als eine Menge aller Strom-Spannungs-Paare mit einer Spannung gleich einem ganzzahligen Vielfachen einer Span-nungsauflösung innerhalb eines vorgewählten Aus-gangsspannungsbereiches und einem Strom, welcher Strom, innerhalb des vorgewählten Ausgangsstrombereiches liegend, ein ganzzahliges Vielfaches der vorgewählten Stromauflösung darstellt.

Im Rahmen einer wesentlichen Weiterbildung des Verfahrens wird die Kleinsignal-Kenngröße gewählt aus den Größen:

- maximal erzielbare Leistungsverstärkung,
- maximale stabile Leistungsverstärkung,
- bei Reflektionsfreiheit am Eingang maximal erzielbare Leistungsverstärkung,
- bei Reflektionsfreiheit am Eingang maximale stabile Leistungsverstärkung,
- unter Minimierung der Rauschzahl maximal erzielbare Leistungsverstärkung,
- unter Minimierung der Rauschzahl maximale stabile Leistungsverstärkung.

Im Rahmen einer wesentlichen Weiterbildung des Verfahrens ist die Kleinsignal-Kenngröße die sich entlang der Lastlinien ergebende Leistungsverstärkung bei Eingangs- und Ausgangsimpedanzen, welche im Stütz-Arbeitspunkt eine der Bedingungen erfüllen:

- die Ein- und Ausgangsimpedanzen maximieren die erzielbare Leistungsverstärku ng,
- die Ein- und Ausgangsimpedanzen maximieren die stabil erzielbare Leistungsverstärku ng,
- die Ein- und Ausgangsimpedanzen maximieren die erzielbare Leistungsverstärkung bei Reflektionsfreiheit am Eingang,
- die Ein- und Ausgangsimpedanzen maximieren die stabil erzielbare Leistungsverstärkung bei Reflektionsfreiheit am Eingang,
- die Ein- und Ausgangsimpedanzen maximieren die erzielbare Leistungsverstärkung unter Minimierung der Rauschzahl,
- die Ein- und Ausgangsimpedanzen maximieren die stabil erzielbare Leistungsverstärkung unter Minimierung der Rauschzahl,
- die Ein- und Ausgangsimpedanzen sind anderweitig für den Betrieb im Stütz-Arbeitspunkt zweckdienlich gewählt.

Eine bevorzugte Weiterbildung der Erfindung sieht vor, dass zur Bestimmung des Bereiches einer jeden Lastlinie zunächst ein signifikanter Wert, insbesondere ein zumindest lokales Extremum, des Wertes der Kleinsignal-Kenngröße entlang der Lastlinie bestimmt wird, sowie als Bereich derjenige zusammenhängende, das zumindest lokale Extremum enthaltende Abschnitt der Lastlinie gewählt wird, in welchem der Wert der Kleinsignal-Kenngröße um nicht mehr als einen bestimmten Faktor, bspw. 3 dB, von dem zumindest lokalen Extremum abweicht.

Großsignal-Kenngrößen ergeben sich als Integral der ihnen entsprechenden Kleinsignal-Parameter des betrachteten Bauelementes oder Schaltkreises über der Großsignal-Ausgangskennlinie. Soll insbesondere im Rahmen des Schaltungsdesigns ein Arbeitspunkt gefunden werden, an dem eine Großsignal-Kenngröße in möglichst geringem Maße von der Aussteuerung abhängt, so kann diese Aufgabe unter anderem dadurch gelöst werden, dass eine Ausgangskennlinie gewählt wird, entlang derer der Kleinsignal-Parameter, dessen integraler Wert die Großsignal-Kenngröße ergibt, die geringst mögliche Variation aufweist.

Zum Zwecke der näherungsweisen Bestimmung einer derartigen Kennlinie werden daher im Rahmen der betrachteten Weiterbildung des Verfahrens vorteilhaft zunächst Bereiche entlang der, zumindest näherungsweisen, Lastlinien gesucht, innerhalb derer die Variation des betrachteten Kleinsignal-Parameters in geeigneter Weise begrenzt ist.

Eine bevorzugte Weiterbildung der Erfindung sieht vor, dass der Bereich einer jeden Lastlinie bestimmt wird als derjenige Abschnitt maximaler Ausdehnung der Lastlinie, in welchem der Wert der Kleinsignal-Kenngröße sich mit einer gegebenen Genauigkeit durch einen bestimmten Kurvenverlauf, beispielsweise einen symmetrischen paraboloiden Verlauf, beschreiben lässt.

Vorteilhaft soll im Rahmen des Schaltungsdesigns nicht eine geringst mögliche Variation, sondern ein gewünschter nichtkonstanter Verlauf einer Großsignal-Kenngröße über der Auslenkung realisiert werden. Ein Beispiel hierfür stellen vorverzerrende Vorstufen dar, durch deren Einsatz die Aussteuerungsabhängigkeit der Verstärkung der Haupt-Verstärkerstufe kompensiert werden soll. Da an geeigneten Arbeitspunkten geringst möglicher Verzerrung des Haupt-Verstärkers dessen Kleinsignal-Verstärkung häufig mit dem Quadrat der Auslenkung abnimmt, erleichtert die betrachtete Weiterbildung der Erfindung insbesondere die Auslegung vorverzerrender Vorstufen.

Eine bevorzugte Weiterbildung der Erfindung sieht vor, dass zumindest eine der Grenzen des Bereiches einer jeden Lastlinie durch, beispielsweise quadratische, Extrapolation bis zu zumindest einem Punkt, an welchem Punkt der extrapolierte Wert der Kleinsignal-Kenngröße eine bestimmte Eigenschaft aufweist, bestimmt wird.

Insbesondere aufgrund von Unzulänglichkeiten der, beispielsweise Bipolartransistoren beschreibenden, Modelle steigt im Spannungsbereich kurz vor dem Basis-Emitter-Durchbruch die statisch errechnete Leistungsverstärkung an. Die beschriebene Weiterbildung des Verfahrens erlaubt insbesondere, derartige Modell-Artefakte bei der Suche nach geeigneten Arbeitspunkten herauszurechnen.

Eine bevorzugte Weiterbildung der Erfindung sieht vor, dass als Bereich der Ort des Maximums der Kleinsignal-Kenngröße entlang der Lastlinie gewählt wird.

Ein Aspekt der Erfindung beinhaltet, dass die der Lastlinie zugeordnete Großsignal-Kenngröße aus dem Verlauf der Kleinsignal-Kenngröße innerhalb des Bereiches zumindest näherungsweise ermittelt wird, indem vorzugsweise der Wert der Großsignal-Kenngröße am Ort des Maximums der Kleinsignal-Kenngröße entlang der Lastlinie gewählt wird. Alternativ kann auch ein Durchschnittswert oder ein Integralwert als Wert für die Großsignal-Kenngröße dienen.

Eine bevorzugte Weiterbildung dieses Aspekts der Erfindung sieht vor, dass als Großsignal-Kenngröße eine oder mehrere der Größen:

- Intermodulationsprodukt der Ordnung n, insbesondere mit n=2 oder n=3,
- harmonische Verzerrung n-ter Ordnung, insbesondere mit n von 2 bis 5,
- Klirrfaktor

gewählt wird.

Bei, insbesondere kleinen, Auslenkung eines Bauelementes oder Schaltkreises um einen Arbeitspunkt herum, in welchem die Verstärkung ein lokales Extremum aufweist, ergibt sich ein besonders verzerrungsarmer Betrieb. Durch die Berücksichtigung des Verlaufes der Kleinsignal-Kenngröße entlang von Lastlinien lassen sich im Rahmen des erfindungsgemäßen Verfahrens insbesondere auf vorteilhafte Weise und automatisierbar derartige lokale Extrema ermitteln sowie hierdurch unter allen Arbeitspunkten einer, zumindest näherungsweisen, Lastlinie diejenigen herausfiltern, durch die ein besonders verzerrungsarmer Betrieb ermöglicht wird.

In einer Weiterbildung des Verfahrens wird ein Arbeitspunkt innerhalb des Bereiches ermittelt und die ermittelte Großsignal-Kenngröße dem ermittelten Arbeitspunkt zugeordnet. Zur Ermittlung des Arbeitspunktes ist in einer vorteilhaften Ausgestaltung der Erfindung vorgesehen, die Lage des Arbeitspunktes aus Lage und Ausdehnung des Gebietes zu bestimmen. Im Rahmen einer besonders bevorzugten Ausgestaltungsform wird hierbei die Lage des Arbeitspunktes gleich der Lage des geometrischen Schwerpunktes des Bereiches gewählt.

Gemäß einer vorteilhaften Ausgestaltung der Erfindung ist vorgesehen, dass unter den ermittelten Arbeitspunkten derjenige ausgezeichnete Arbeitspunkt mit dem bestgewünschten unter allen, den ermittelten Arbeitspunkten zugeordneten, Werten der ermittelten Großsignal-Kenngröße als Näherungslösung für einen den Wert der Großsignal-Kenngröße optimierenden Arbeitspunkt, sowie der dem ausgezeichneten Arbeitspunkt zugeordnete Wert der ermittelten Großsignal-Kenngröße als Näherungslösung für den optimalen Wert der Großsignal-Kenngröße herangezogen wird.

Die Erfindung bevorzugt weiterzubilden, umfasst, dass die Suche nach einem den Wert der ermittelten Großsignal-Kenngröße optimierenden ausgezeichneten Arbeitspunkt des betrachteten aktiven Bauelementes oder Schaltkreises auf einen vorgegebenen Bereich an Ausgangsspannungen und/oder Ausgangsströmen, insbesondere Kollektorströmen, beschränkt wird. Namentlich bei der Auslegung batteriebetriebener Bauelemente oder Schaltungen ist der Designer eng begrenzt in der Wahl der Versorgungsspannung. Insbesondere in solchen Fällen wird durch die vorliegende Weiterbildung das Schaltungsdesign unterstützt.

Ein weiterer wesentlicher Aspekt der Erfindung ist die graphische Darstellung des Ergebnisses, die beispielsweise auf einem Display beispielsweise eines Messgerätes oder eines Rechnersystems angezeigt werden kann. Demnach ist in einer vorteilhaften Weiterbildung dieses Aspektes der Erfindung vorgesehen, dass mehrere ermittelte Werte der Großsignal-Kenngröße in Abhängigkeit von dem jeweils zugeordneten Arbeitspunkt über mehrere Spannungswerte und Stromwerte vorzugsweise eines Ausgangskennlinienfeldes graphisch dargestellt werden.

Um die graphische Darstellung zu optimieren, ist in einer Ausgestaltung dieser Weiterbildung der Erfindung vorgesehen, dass die graphische Darstellung für zumindest ein ausgewähltes Blatt einer Abbildung erfolgt, insbesondere wenn die Abbildung der ermittelten Werte der Großsignal-Kenngröße in den Arbeitspunkten mehrwertig ist.

Insbesondere bei Auftragung von Großsignal-Kenngrößen in Bezug zu Lastlinien, welche einen weiten Bereich von Lastbedingungen überdecken, kann sich der Fall ergeben, dass eine Wahl ein und desselben Punkts des Ausgangskennlinienfeldes den Wert der Großsignal-Kenngröße in mehreren Bereichen unterschiedlicher Kennlinien optimiert. Im Allgemeinen werden sich hierbei jedoch die optimalen Werte der Großsignal-Kenngröße für die verschiedenen Bereiche unterschieden. Im Interesse der Klarheit der Darstellung ist es insbesondere in solchen Fällen vorteilhaft, die Darstellung auf ein ausgewähltes Blatt der optimalen Werte der Großsignal-Kenngröße zu beschränken. Besonders bevorzugt erfolgt die graphische Darstellung in Form von Isohypsen der ermittelten Werte der Großsignal-Kenngröße über den Arbeitspunkten.

Zur Unterstützung beim Entwurf elektronischer Schaltungen ist in einer bevorzugten Weiterbildung zielführend, dass ein eine Effizienz der Leistungsverstärkung eines aktiven Bauelementes oder eines Verstärkerschaltkreises maximierender Arbeitspunkt zumindest näherungsweise ermittelt wird, indem zunächst

- zu jedem Arbeitspunkt aus einer Menge von Stütz-Arbeitspunkten sowie
- zu jeder Lastimpedanz aus einer Menge von Lastimpedanzen
- entlang einer Lastlinie, welche Lastlinie eine Lastlinie durch den Arbeitspunkt zu der Lastimpedanz sowie zu einer, am jeweiligen Arbeitspunkt zu der Lastimpedanz zweckdienlich gewählten Eingangsimpedanz, annähert,

als Verlauf einer Kleinsignal-Kenngröße ein Verlauf der Kleinsignal-Leistungsverstärkung bestimmt wird. Zudem wird als signifikanter Wert ein zumindest lokales Maximum der Kleinsignal-Leistungsverstärkung entlang jeder Lastlinie bestimmt.

In einer anderen Weiterbildung des Verfahrens wird der Arbeitspunkt innerhalb des Bereiches derart ermittelt, insbesondere derart abgeschätzt, dass an diesem Arbeitspunkt die Effizienz der Leistungsverstärkung innerhalb des Bereiches maximiert wird. Zudem wird die maximale Effizienz der Leistungsverstärkung innerhalb des Bereiches in Abhängigkeit von einer Ausdehnung des zusammenhängenden Bereichs und der Lage des Arbeitspunktes ermittelt, insbesondere abgeschätzt, sowie die dergestalt ermittelte, insbesondere abgeschätzte, maximale Effizienz der Leistungsverstärkung innerhalb des Bereiches dem dergestalt ermittelten, insbesondere abgeschätzten, Arbeitspunkt zugeordnet.

Diesen Aspekt der Erfindung weiterbildend ist vorgesehen, dass unter allen dergestalt ermittelten, die Effizienz der Leistungsverstärkung innerhalb der jeweiligen Bereiche näherungsweise maximierenden Arbeitspunkten derjenige mit maximaler ermittelter Effizienz der Leistungsverstärkung als Abschätzung für einen die Effizienz der Leistungsverstärkung maximierenden Arbeitspunkt ausgewählt wird.

Eine andere Weiterbildung dieses Aspektes sieht vor, dass als Abschätzung für die maximale Effizienz der Leistungsverstärkung die Größte unter den innerhalb der Bereiche maximalen Effizienzen der Leistungsverstärkung gewählt wird.

Ein weiterer Aspekt der Erfindung sieht vor, dass dasjenige unter den Paaren von Quell- und Lastimpedanzen, welches auf diejenige Lastlinie führt, Teilmenge welcher ein Bereich ist, innerhalb wessen ein dergestalt abgeschätzter, die Effizienz der Leistungsverstärkung innerhalb des Bereiches näherungsweise maximierender Arbeitspunkt liegt, als ein die Effizienz der Leistungsverstärkung an dem dergestalt abgeschätzten Arbeitspunkt näherungsweise maximierendes, abgeschätztes Paar aus Quell- und Lastimpedanzen herangezogen wird.

Eine wesentliche Kenngröße für das Design von Verstärkerschaltungen ist die Effizienz als Verhältnis der Ausgangsleistung in Beziehung zur Ruheleistung des Verstärkers. In der CAD-Technik wie auch in der Messtechnik erfolgt die Ermittlung von effizienzoptimierten Betriebsbedingungen insbesondere durch Load-Pull-, respektive Source-Pull-Verfahren bei festgehaltenen Arbeitspunkt. Während der zu diesem Zwecke zu betreibende Aufwand eine Untersuchung mehrere oder vieler Arbeitspunkte stark behindert, erlaubt das zuvor genannte Verfahren der vorangehenden Weiterbildungen, im Falle von CAD-Verfahren auf numerisch effektive Weise, und im Falle der messtechnischen Erfassung mit bedeutend geringerem Aufwand, die Suche nach effizienzoptimierenden Betriebsbedingungen, im Ausgangskennlinienfeld ebenso wie im Raum der Last- und Quellimpedanzen.

Gemäß einer Weiterbildung ist vorgesehen, dass die Menge von Stütz-Arbeitspunkten konstruiert wird gemäß der Vorschrift:

- Wahl einer ersten Anzahl, welche erste Anzahl beispielsweise gleich einer Anzahl von 100 sein kann,
- Wahl eines ersten Punktes, welcher erste Punkt beispielsweise gleich dem Ursprung eines Ausgangskennlinienfeldes des betrachteten Bauelementes oder Verstärkerschaltkreises sein kann,
- Wahl eines zweiten Punktes im Ausgangskennlinienfeld des betrachteten Bauelementes oder Verstärkerschaltkreises, welcher zweite Punkt beispielsweise der Punkt zu der maximal über dem Bauelement oder Verstärkerschaltkreis zulässigen Sperrspannung sowie zu dem maximal über dem Bauelement oder Verstärkerschaltkreis zulässigen Strom sein kann,
- Wahl einer Strecke zwischen dem ersten Punkt und dem zweiten Punkt im Ausgangskennlinienfeld, welche Strecke beispielsweise Teil einer Geraden sein kann,
- Unterteilung der Strecke in eine erste Anzahl von Punkten, welche Unterteilung beispielsweise äquidistant erfolgen kann,
- Wahl der Gesamtheit der ersten Anzahl von Punkten als Menge von Stützarbeitspunkten.

Bevorzugt ist dabei vorgesehen, dass die Menge von Lastimpedanzen konstruiert wird gemäß der Vorschrift:

- Wahl einer zweiten Anzahl, welche zweite Anzahl beispielsweise gleich einer Anzahl von 300 sein kann,
- Wahl einer zweiten Anzahl von Lastreflektionsfaktoren beispielsweise dergestalt, dass die Lastreflektionsfaktoren den passiven Teil der Reflektionsfaktorebene annähernd gleichmäßig überdecken,
- Bestimmen der zu einem Lastreflektionsfaktor aus der zweiten Anzahl von Lastreflektionsfaktoren gehörigen Lastimpedanz,
- Wahl der Gesamtheit der zweiten Anzahl der zu einem der Lastreflektionsfaktoren gehörigen Lastimpedanzen als Menge von Lastimpedanzen.

Bei einer bevorzugten Ausgestaltungsform ist fernerhin die Wahl der Menge von Lastlinien als Gesamtheit derjeniger ohmscher Lastlinien durch den Arbeitspunkt

- zu dem ohmschen Anteil einer beliebigen aus der zweiten Anzahl von Lastreflektionsfaktoren, sowie
- zu einer bei dem gegebenen Arbeitspunkt und der gegebenen Lastimpedanz zweckdienlichen Eingangsimpedanz

vorgesehen.

In einer Ausgestaltung der Erfindung erfolgt eine Wahl einer bei der betrachteten Lastimpedanz und dem betrachteten Arbeitspunkt zweckdienlichen Eingangsimpedanz als Wahl derjenigen Eingangsimpedanz, welche einem Quellenreflektionsfaktor entspricht, der das komplex Konjugierte des bei der betrachteten Lastimpedanz und dem betrachteten Arbeitspunkt am Eingang des aktiven Bauelementes oder Verstärkerschaltkreises gesehenen Eingangsreflektionsfaktors darstellt.

In einer anderen Ausgestaltung der Erfindung erfolgt eine Wahl einer bei der betrachteten Lastimpedanz und dem betrachteten Arbeitspunkt zweckdienlichen Eingangsimpedanz als Wahl derjenigen Eingangsimpedanz, welche einem Quellenreflektionsfaktor entspricht, der gleich dem bei der betrachteten Lastimpedanz und dem betrachteten Arbeitspunkt am Eingang des aktiven Bauelementes oder Verstärkerschaltkreises gesehenen Eingangsreflektionsfaktors ist.

In einer wiederum anderen Ausgestaltung der Erfindung erfolgt eine Wahl einer bei der betrachteten Lastimpedanz und dem betrachteten Arbeitspunkt zweckdienlichen Eingangsimpedanz als Wahl derjenigen Eingangsimpedanz, welche bei der betrachteten Lastimpedanz und dem betrachteten Arbeitspunkt die Rauschzahl des aktiven Bauelementes oder Verstärkerschaltkreises minimiert.

Gemäß einer vorteilhaften Ausgestaltung der Erfindung erfolgt eine Wahl der zweiten Anzahl von Lastreflektionsfaktoren dergestalt, dass ein Lastreflektionsfaktor mit einer Ordnungsnummer gewählt wird als Produkt aus

- erstens der Wurzel aus dem Quotienten der Ordnungsnummer und der zweiten Anzahl und
- zweitens der zur Basis der Euler'schen Zahl e exponentierten Wurzel aus dem Negativen des Produktes von viermal der Kreiszahl p mit der Ordnungsnummer,
- für jede natürliche Zahl kleiner als die zweite Anzahl oder gleich der zweiten Anzahl als Ordnungsnummer.

Durch eine derartige Wahl lässt sich der passive Teil der Last-Reflektionsfaktorebene mit Hilfe einer einzigen Laufvariablen hinreichend gleichmäßig überdecken.

Eine Ausgestaltung bildet eine Abschätzung der maximierten Effizienz der Leistungsverstärkung zu einem der, die Effizienz der Leistungsverstärkung über einem Bereich der Lastlinie maximierenden, zweiten Arbeitspunkt und einer Lastlinie aus der Ausdehnung des zusammenhängenden Bereiches sowie der Lage des zweiten Arbeitspunktes, gemäß der Vorschrift

- Wahl eines das Quadrat der Differenz zwischen einem Strom in dem zweiten Arbeitspunkt und einem Strom in einem der Punkte des zusammenhängenden Bereiches mit größerem Strom als dem Strom im zweiten Arbeitspunkt maximierenden ersten Randpunktes,
- Wahl eines das Quadrat der Differenz zwischen dem Strom im zweiten Arbeitspunkt und dem Strom in einem der Punkte des zusammenhängenden Bereiches mit kleinerem Strom als dem Strom im zweiten Arbeitspunkt maximierenden zweiten Randpunktes, sowie
- Abschätzung der Effizienz der Leistungsverstärkung aus der Ausdehnung des zusammenhängenden Bereiches sowie der Lage des zweiten Arbeitspunktes als die Hälfte des Absolutwertes des Produktes aus erstens dem Quotienten aus der Differenz und der Summe der Spannungswerte an den beiden Randpunkten, und zweitens dem Quotienten aus der Differenz und der Summe der Stromwerte an den beiden Randpunkten.

Eine vorteilhafte Ausgestaltung der Erfindung sieht vor, dass zum Zwecke der Bestimmung der Leistungsverstärkung zu der Lastimpedanz und der Eingangsimpedanz entlang der Lastlinie vor Anwendung des Verfahrens einmalig ein Ausgangskennlinienfeld mit einer gegebenen Auflösung in Strom und Spannung bestimmt wird sowie in jedem betrachteten Punkt des Ausgangskennlinienfeldes die Kleinsignalparameter bestimmt werden. Diese Weiterbildung erlaubt eine numerisch respektive messtechnisch besonders einfache Implementierung des Verfahrens.

Bevorzugt werden vor Bestimmung der Maximalwerte der Leistungsverstärkung zur Lastimpedanz und Eingangsimpedanz entlang der Lastlinie die numerisch bestimmten Werte der Leistungsverstärkung zur Lastimpedanz und Eingangsimpedanz entlang der Lastlinie des Verfahrens geglättet.

Weiterhin bevorzugt werden vor Bestimmung der Zielwerte des Verfahrens die bestimmten Werte maximaler Effizienzen der Leistungsverstärkung innerhalb der Bereiche, aufgetragen über Ausgangsstrom und Ausgangsspannung, geglättet.

Um eine schnelle Sichtung der Ergebnisse zu ermöglichen, ist in einer vorteilhaften Ausgestaltung der Erfindung vorgesehen, dass eine graphische Darstellung durch Auftragung der ermittelten Effizienzen der Leistungsverstärkung über Spannungen und Strömen nach einer Einteilung in Größenklassen, vorzugsweise farbkodiert, erfolgt.

Die Erfindung weiter ausgestaltend ist vorgesehen, dass weitere, zu den ermittelten, die Effizienz der Leistungsverstärkung innerhalb der jeweiligen Bereiche näherungsweise maximierenden Arbeitspunkten sowie zu den die Effizienzen der Leistungsverstärkung in den dergestalt abgeschätzten Arbeitspunkten näherungsweise maximierenden, abgeschätzten Paaren aus Quell- und Lastimpedanzen, gehörige Werte bestimmt werden. Derartige Werte sind vorzugsweise die Kleinsignal-Leistungsverstärkung, die Ausgangsleistung, ein effektiver Eingangsreflektionsfaktor und/oder ein effektiver Ausgangsreflektionsfaktor.

Die Erfindung vorrangig weiterbildend, ist vorgesehen, dass weitere Klein-und/oder Großsignalparameter zu den zweiten Arbeitspunkten und den in den Arbeitspunkten die abgeschätzten Effizienzen der Leistungsverstärkung jeweils optimierenden Quell- und Lastreflektionsfaktoren, wie beispielsweise der Kompressionspunkt, die Kleinsignalverstärkung oder die Rauschzahl, insbesondere in Form geglätteter Isohypsen graphisch dargestellt werden.

Bei der Ermittlung zweckdienlicher Betriebsbedingungen elektronischer Bauelemente oder Schaltkreise ist der Designer häufig veranlasst, unterschiedliche, einander widersprechende Zielgrößen gegeneinander abzuwägen. Durch die vorliegende Weiterbildung, die Auftragung weiterer elektrischer Parameter zu den Zielgrößen des erfindungsgemäßen Verfahrens, beispielsweise in Form von Isohypsen, wird eine vorteilhafte, automatisierbare Hilfestellung bei dieser Abwägung zur Verfügung gestellt.

Die Erfindung weiter ausgestaltend ist vorgesehen, dass die Bestimmung der die betrachteten Großsignalparameter optimierenden Betriebsgrößen der aktiven Bauelemente oder Verstärkerschaltkreise auf bei einzeln oder mehreren betrachteten Frequenzen unbedingt stabile zweite Arbeitspunkte beschränkt wird.

Die Erfindung weiter ausgestaltend ist vorgesehen, dass die Bestimmung der die betrachteten Großsignalparameter optimierenden Betriebsgrößen der aktiven Bauelemente oder Verstärkerschaltkreise sich auf Arbeitspunkte beschränkt, an denen zu der betrachteten Frequenz zumindest der Eingangs-oder der Ausgangsreflektionsfaktor dem Betrage nach größer als Eins sind. Die letzten beiden Weiterbildungen werden dabei für den Aufbau von Oszillatoren, bzw. von Verstärkern bevorzugt angewendet.

Eine bevorzugt Weiterbildung der Erfindung sieht vor, dass die Vielzahl von Lastlinien zu Arbeitspunkten, in welchen Arbeitspunkten das aktive Bauelement oder der Verstärkerschaltkreis bei einer betrachteten Frequenz unbedingt stabil ist, gewählt werden gemäß der Vorschrift:

- Wahl einer dritten Anzahl, welche dritte Anzahl beispielsweise gleich der Zahl 30 gewählt werden kann, sowie einer unteren und einer oberen Schwelle, welche untere Schwelle beispielsweise als die Zahl 0.5, und welche obere Schwelle beispielsweise als die Zahl 2 gewählt werden kann.
- Bestimmung eines bei den die Leistungsverstärkung maximierenden Last-und Quellimpedanzen effektiv wirksamen ohmschen Ausgangswiderstandes als Absolutquadrat der die Leistungsverstärkung maximierenden Lastimpedanz, geteilt durch den doppelten Realteil der die Leistungsverstärkung maximierenden Lastimpedanz,
- Unterteilung des Bereiches vom Produkt aus unterer Schwelle und effektiv wirksamem ohmschen Ausgangswiderstand bis zum Produkt aus oberer Schwelle und effektiv wirksamen ohmschen Ausgangswiderstand in eine dritte Anzahl von, beispielsweise äquidistanten, Widerstandswerten,
- zu jedem Widerstandswert aus der dritten Anzahl von Widerstandswerten Bestimmung eines Lastreflektionsfaktors und eines Quellreflektionsfaktors, welche erfüllen, dass der Quellreflektionsfaktor das komplex Konjugierte des effektiven Eingangsreflektionsfaktors ist und dass eine Parallelschaltung des zu dem Lastreflektionsfaktor gehörigen Lastwiderstandes mit dem Ausgangswiderstand des betrachteten aktiven Bauelementes oder Schaltkreises einen rein ohmschen Widerstand von der Größe des Widerstandswertes ergibt, sofern zu diesem Widerstandswert ein solches Paar aus Lastreflektionsfaktor und Quellreflektionsfaktor existiert,

- Wahl der Vielzahl von Lastlinien als die Menge ohmscher Lastlinien durch den Arbeitspunkt zu denjenigen effektiven Widerstandswerten aus der dritten Anzahl von Widerstandswerten, zu denen derartige Lastreflektionsfaktoren und Quellreflektionsfaktoren existieren, sowie gegebenenfalls Wahl der zu den Lastlinien und Arbeitspunkten jeweils zugehörigen Last-und Quellimpedanzen als die zu den oben bestimmten Lastreflektionsfaktoren und Quellreflektionsfaktoren gehörigen Last- beziehungsweise Quellimpedanzen.

Kollabiert eine Lastlinie einer Ausgangskennlinie auf eine Widerstandgerade, so sind Ausgangsstrom und Ausgangsspannung des aktiven Elementes in Phase, das Element leistet keine Blind-, sondern ausschließlich Wirkleistung. Einen Sonderfall hiervon stellt die so genannte "Leistungsanpassung" dar: Mit Hilfe eines Anpassnetzwerkes wird der Eingangswiderstand der Last in das komplex Konjugierte des Ausgangswiderstandes des aktiven Elementes transformiert.

Die Steigung der ohmschen Lastgeraden bestimmt sich hierbei aus der Parallelschaltung des (effektiven) Ausgangswiderstandes des aktiven Elementes und des Eingangswiderstandes der Last aus dem (effektiven) Ausgangswiderstand als das Absolutquadrat, geteilt durch zweimal den Realteil des (effektiven) Ausgangswiderstandes.

Die Leistungsanpassung stellt insbesondere insoweit einen technisch wichtigen Sonderfall dar, als dass sich durch Leistungsanpassung die Leistungsverstärkung eines aktiven Elementes maximieren lässt. Die hier beschriebene Weiterbildung des Verfahrens bestimmt näherungsweise Betriebsbedingungen eines aktiven Bauelementes oder Schaltkreises, welche die Effizienz der Leistungsverstärkung unter der Randbedingung der Leistungsanpassung am Eingang maximieren.

In einer anderen vorteilhaften Weiterbildung der Erfindung ist vorgesehen, dass die Vielzahl von Lastlinien zu Arbeitspunkten, in welchen Arbeitspunkten das aktive Bauelement oder der Verstärkerschaltkreis bei einer betrachteten Frequenz unbedingt stabil ist, gewählt werden gemäß der Vorschrift:

- Wahl einer dritten Anzahl, welche dritte Anzahl beispielsweise gleich der Zahl 30 gewählt werden kann, sowie einer unteren und einer oberen Schwelle, welche untere Schwelle beispielsweise als die Zahl 0.5, und welche obere Schwelle beispielsweise als die Zahl 2 gewählt werden kann,

- Bestimmung von Paaren aus Last- und Quellimpedanzen zu den Arbeitspunkten, welche Paare erfüllen, dass der zu der Quellimpedanz gehörige Quellreflektionsfaktor gleich dem effektiven Eingangsreflektionsfaktor ist, und dass der zu der Lastimpedanz gehörige Lastreflektionsfaktor gleich dem komplex Konjugierten des effektiven Ausgangsreflektionsfaktors des betrachteten aktiven Bauelementes oder Verstärkerschaltkreises ist,

- Bestimmung eines bei der betrachteten Quellimpedanz und Lastimpedanz effektiv wirksamen ohmschen Ausgangswiderstandes als Absolutquadrat der Lastimpedanz, geteilt durch 2 mal den Realteil der Lastimpedanz,

- Unterteilung des Bereiches vom Produkt aus unterer Schwelle und effektiv wirksamen ohmschen Ausgangswiderstand bis zum Produkt aus oberer Schwelle und effektiv wirksamen ohmschen Ausgangswiderstand in eine dritte Anzahl von, beispielsweise äquidistanten, Widerstandswerten,

- zu jedem Widerstandswert aus der dritten Anzahl von Widerstandswerten Bestimmung des Lastreflektionsfaktors und Quellreflektionsfaktors, welche die Bedingungen erfüllen, dass der Quellreflektionsfaktor gleich dem effektiven Eingangsreflektionsfaktor ist, und dass eine Parallelschaltung des zu dem Lastreflektionsfaktor gehörigen Lastwiderstandes mit dem Ausgangswiderstand des betrachteten aktiven Bauelementes oder Schaltkreises einen rein ohmschen Widerstand von der Größe des Widerstandswertes ergibt, sofern zu diesem Widerstandswert ein solches Paar aus Lastreflektionsfaktor und Quellreflektionsfaktor existiert,

- Wahl der Vielzahl von Lastlinien als die Menge ohmscher Lastlinien durch den Arbeitspunkt zu denjenigen effektiven Widerstandswerten aus der zweiten Anzahl von Widerstandswerten, zu denen derartige Lastreflektionsfaktoren und Quellreflektionsfaktoren existieren, gegebenenfalls Wahl der zu den Lastlinien und Arbeitspunkten jeweils zugehörigen Last- und Quellimpedanzen als die zu den oben bestimmten Lastreflektionsfaktoren und Quellreflektionsfaktoren gehörigen Last- beziehungsweise Quellimpedanzen.

Einen weiteren technisch wichtigen Sonderfall neben der Leistungsanpassung stellt eine Anpassung dar, bei der durch die ausgangsseitige Anpassung die Leistungsverstärkung unter der Nebenbedingung "Reflektionsfreiheit am Eingang" näherungsweise maximiert wird. Die hier beschriebene Weiterbildung des Verfahrens bestimmt näherungsweise Betriebsbedingungen eines aktiven Bauelementes oder Schaltkreises, welche die Effizienz der Leistungsverstärkung unter dieser Randbedingung maximieren.

In einer Weiterbildung Erfindung werden die Lastlinien gewählt, ausgehend von einer vorgewählten Testspannung, einem vorgewählten Ausgangsspannungsbereich und einer vorgewählten Spannungsauflösung, sowie einem vorgewählten Ausgangsstrombereich und einer vorgewählten Stromauflösung, gemäß der Vorschrift:

- Wahl einer erste Menge von Stütz-Arbeitspunkten als eine Menge aller Strom-Spannungs-Paare mit einer Spannung gleich einem ganzzahligen Vielfachen einer Spannungsauflösung innerhalb eines vorgewählten Ausgangsspannungsbereiches und einem Strom, welcher Strom, innerhalb des vorgewählten Ausgangsstrombereiches liegend, ein ganzzahliges Vielfaches der vorgewählten Stromauflösung darstellt,

sowie für jeden der Stütz-Arbeitspunkte:

- Bestimmung der effektiven Ausgangimpedanz des aktiven Elementes oder Verstärkerschaltkreises unter der Bedingung von Leistungsanpassung am Ausgang sowie einer problemangepasst gewählten Anpassbedingung am Eingang des aktiven Elementes oder Verstärkerschaltkreises,

- Bestimmung einer ersten Geradensteigung als das Absolutquadrat der effektiven Ausgangimpedanz, geteilt durch zweimal den Realteil der effektiven Ausgangimpedanz,

- Variation der ersten Geradensteigung zu einer variierten Geradensteigung, sowie selbstkonsistente Bestimmung einer Lastimpedanz, bei welcher Lastimpedanz eine Parallelschaltung von,
erstens, der effektiven Ausgangimpedanz des aktiven elektronischen Bauelementes oder der Verstärkerschaltung im Stütz-Arbeitspunkt bei gegebener Anpassbedingung am Eingang des aktiven Elementes oder Verstärkerschaltkreises, sowie
zweitens, der Lastimpedanz,
einen reellen Wert gleich der variierten Geradensteigung aufweist,

- Bestimmung des Verlaufs der Leistungsverstärkung entlang eines geeignet gewählten Abschnittes der Geraden mit variierte Geradensteigung durch den Stütz-Arbeitspunkt bei einer Last gleich der selbstkonsistent bestimmten Lastimpedanz sowie bei der gegebenen Anpassbedingung am Eingang des aktiven Elementes oder Verstärkerschaltkreises,

- Wahl desjenigen größten zusammenhängenden Abschnittes der Geraden mit variierte Geradensteigung, welcher den Stütz-Arbeitspunkt enthält, und in welchem die Leistungsverstärkung bei der selbstkonsistent bestimmten Lastimpedanz sowie der aus der Anpassbedingung am Eingang im Stütz-Arbeitspunkt bestimmten Quellimpedanz höchstens eine vorgegebene Variation aufweist, sowie Wahl eines neuen Verlaufs der Leistungsverstärkung als Einschränkung des Verlaufs der Leistungsverstärkung auf den Abschnitt,

- Wahl derjenigen unter den selbstkonsistent bestimmten Lastimpedanzen zu den variierten Geradensteigungen, bei welcher der neue Verlauf der Leistungsverstärkung die geringste Abweichung von einem symmetrischen oder anderen gewünschten Verlauf aufweist,

- Wahl der Geraden mit variierte Geradensteigung durch den Stütz-Arbeitspunkt als Lastlinie durch den Stütz-Arbeitspunkt.

Selbstverständlich lässt sich durch Iteration des erfindungsgemäßen Verfahrens beispielsweise in der vorliegenden Weiterbildung unter geeigneter Anpassung des vorgewählten Ausgangsspannungs- und/oder Ausgangsstrombereiches auf numerisch effiziente Art eine beliebige Auflösung, mit welcher insbesondere ein optimierter Arbeitspunkt abgeschätzt wird, erzielen.

Die Steigung bei vorliegender Leistungsanpassung am Ausgang und geeignet gewählten Bedingungen am Eingang eines aktiven Elementes ist im Allgemeinen abhängig vom Ort im Ausgangskennlinienfeld.

Insbesondere wird sich im Großsignalbetrieb der Ausgang eines aktiven Elementes nur in Ausnahmefällen auch bei großen Auslenkungen um einen Arbeitspunkt A herum exakt auf einer Widerstandsgeraden bewegen.

Die Steigung ändert sich bei Durchschreiten des Ausgangskennlinienfeldes im Allgemeinen jedoch stetig, so dass sich der Wert der Steigung an einem zweiten Punkt im Ausgangskennlinienfeld in erster Näherung abschätzen lässt durch den Wert der Steigung an einem ersten Punkt, insbesondere, wenn der erste und der zweite Punkt in einem geeigneten Sinne im Ausgangskennlinienfeld "nahe beieinander" liegen. Das Folgende geht daher, als gedankliche Konstruktion zur Plausibilisierung des verwendeten Ansatzes, davon aus, dass sich der Ausgang eines aktiven Elementes bei vorliegender Leistungsanpassung und Auslenkung um einen Arbeitspunkt herum in hinreichender Näherung auf einem Geradenabschnitt mit einer Steigung durch den Arbeitspunkt bewegt. Im Rahmen der gemachten Näherung der Ausgangskennlinie durch den Geradenanschnitt lässt sich die Leistungsverstärkung an einem Ort entlang der Lastgerade gleichsetzen mit der an diesem Ort erzielbaren maximalen Leistungsverstärkung.

Bezüglich dem Verhältnis zwischen einer Isohypse konstanter maximaler Leistungsverstärkung durch den Arbeitspunkt und dem Geradenabschnitt lassen sich zwei Fälle unterscheiden: Der Geradenabschnitt kann die Isohypse schneiden oder tangieren.

Im Falle eines Schnittpunktes zwischen dem Geradenabschnitt und der Isohypse verhält sich die (der jeweils maximal erzielbaren Leistungsverstärkung gleichgesetzte) auslenkungsabhängige Leistungsverstärkung bei Auslenkungen hin zu größeren Spannungen nicht symmetrisch zu Auslenkungen hin zu kleineren Spannungen. Als direkte Folge der nicht-verschwindenden linearen Taylorkomponente der Leistungsverstärkung im Arbeitspunkt ergibt sich bei einer sinusförmigen Anregung mit Anregungsfrequenz am Eingang des aktiven Elementes eine nicht-verschwindende Fourierkomponente des Signals am Ausgang zu der zweifachen Anregungsfrequenz.

Tangiert jedoch der Geradenabschnitt die Isohypse, so verschwindet die lineare Taylorkomponente der Leistungsverstärkung im Arbeitspunkt, und das Ausgangssignal weist (neben der Anregungsfrequenz selbst) lediglich höhere Harmonische der Anregungsfrequenz auf. Arbeitspunkte, bei denen der Geradenabschnitt die Isohypse konstanter maximaler Leistungsverstärkung durch den Arbeitspunkt tangiert, versprechen somit einer geringere Verzerrung, als Arbeitspunkte, bei denen der Geradenabschnitt durch den Arbeitspunkt die Isohypse konstanter maximaler Leistungsverstärkung schneidet.

Während sich die Abweichung des Ausgangssignals von einem sinusoiden Verlauf bei harmonischer Anregung am Eingang exakt durch den "Klirrfaktor" THD (total harmonic distortion) quantifizieren lässt, hat sich in der Praxis herausgestellt, dass sich für die Mehrzahl von Betriebsbedingungen vieler aktiver Elemente Linearitätseigenschaften hinreichend genau mit Hilfe einer der Simulation einfacher zugängigen Größte abschätzen lassen, der Kompressionsleistung, quantifizierbar beispielsweise durch den 1-dB-Kompressionspunkt, $P_{-1dB}$. Der 1-dB-Kompressionspunkt $P_{-1dB}$ gibt, bei Auslenkung um einen Arbeitspunkt herum, diejenige Ausgangsleistung an, bei der die integrale Leistungsverstärkung um 1 dB vom Kleinsignalwert im Arbeitspunkt abgefallen ist.

In einem Extremum der Leistungsverstärkung entlang eines Geradenabschnitts tangiert eine Isohypse konstanter Leistungsverstärkung den Geradenabschnitt. Durch das beschriebene Verfahren lassen sich hiernach insbesondere zunächst Arbeitspunkte bestimmen, in welchen Arbeitspunkten die Geradenabschnitte die Isohypsen durch die jeweiligen Arbeitspunkte tangieren, hiernach also eine verschwindende Fourierkomponente des Ausgangssignals bei der doppelten Frequenz einer sinusoiden Eingangsanregung erwartet werden kann; des weiteren wird kraft der Näherungen "Ersetzung der tatsächlichen Lastlinie durch den Geradenabschnitt" sowie "Ersetzung der tatsächlichen Leistungsverstärkung in einem Punkt entlang des Geradenabschnitts durch die maximal an diesem Punkt erreichbare Leistungsverstärkung" Auslenkungen um die Arbeitspunkte herum abgeschätzt, weiche zu einer Kompression der integralen Leistungsverstärkung um 1 dB führen.

Des Weiteren werden die bei 1 dB Kompression erreichbaren Effizienzen der Leistungsverstärkung in den Arbeitspunkten, sowie Arbeitspunkte mit maximaler Effizienz der Leistungsverstärkung, und somit zu gegebener Effizienz der Leistungsverstärkung geringst möglicher Verzerrung, abgeschätzt.

Auf diese Weise lassen sich auf numerisch einfache Weise klinfaktor-, beziehungsweise leistungseffizienz-optimierende Arbeitspunkte von aktiver elektronische Bauelemente oder Schaltungen abschätzen.

Ein wiederum anderer Aspekt der Erfindung ist eine elektronische Datenverarbeitungsanlage mit einer Anzeigevorrichtung zur grafischen Darstellung, die ausgebildet und eingerichtet ist, ein zuvor erläutertes Verfahren auszuführen.

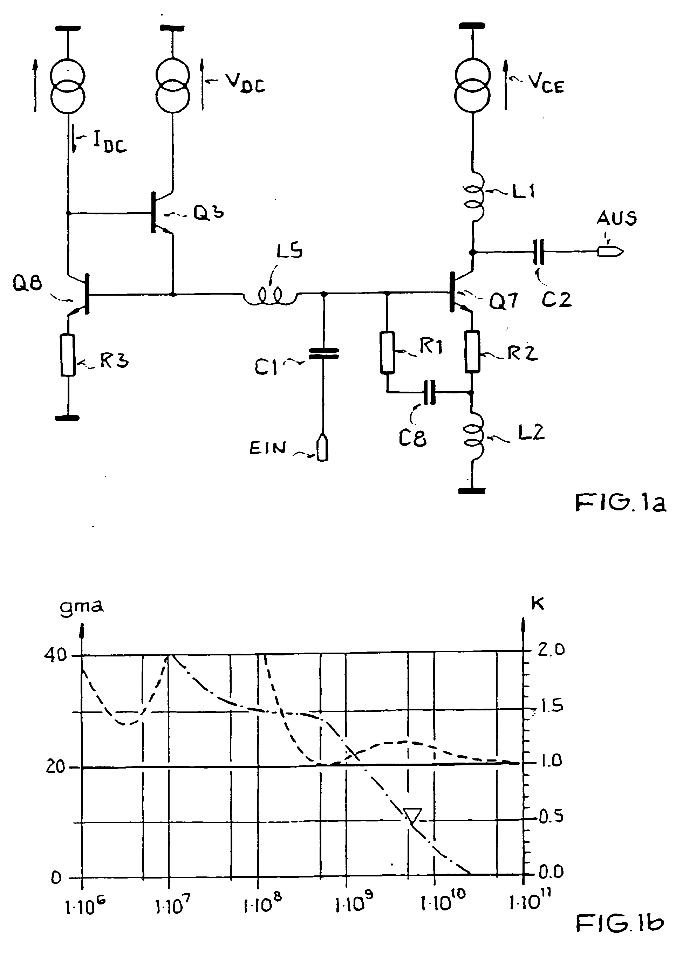

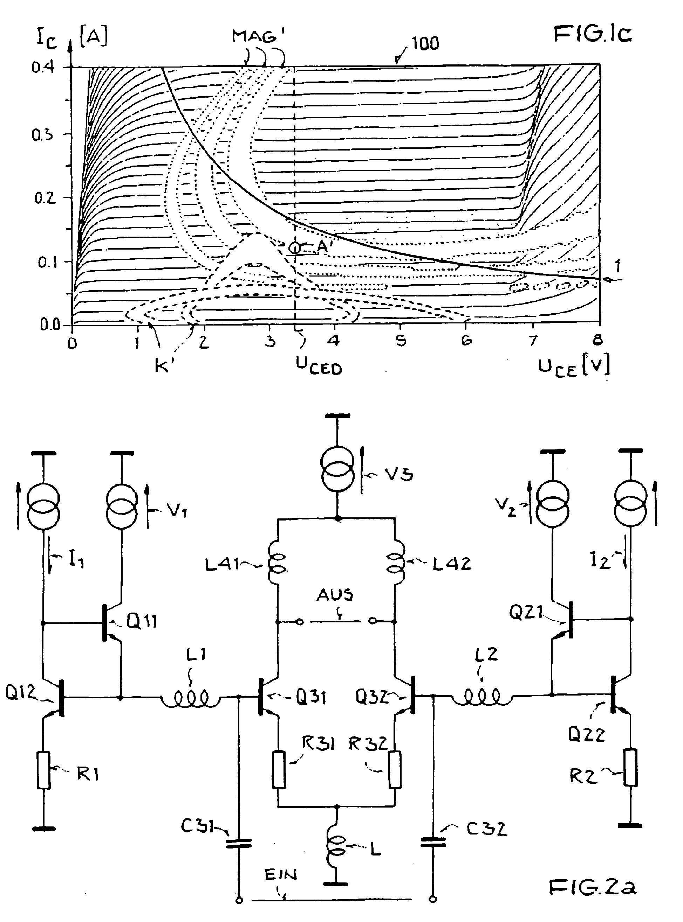

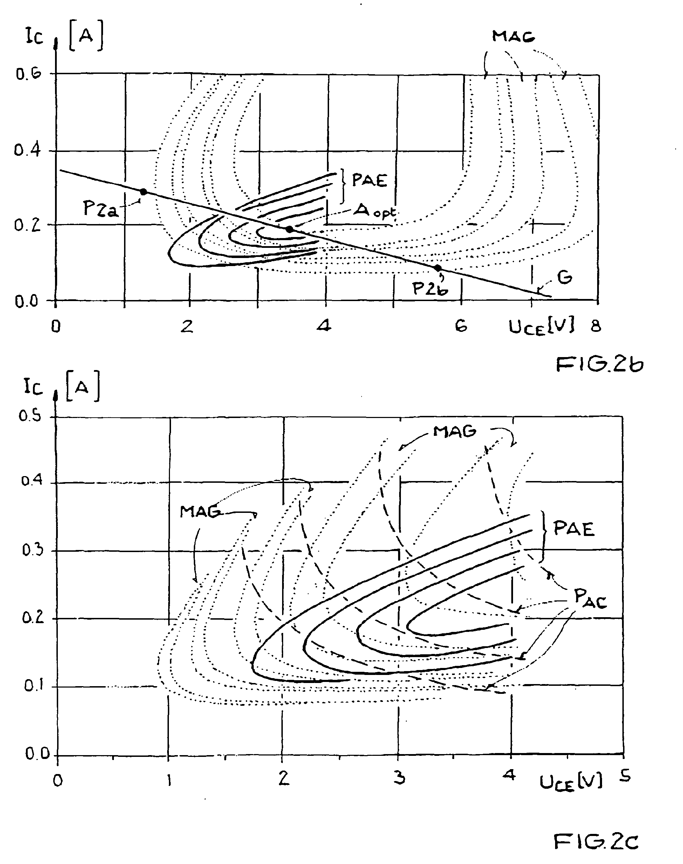

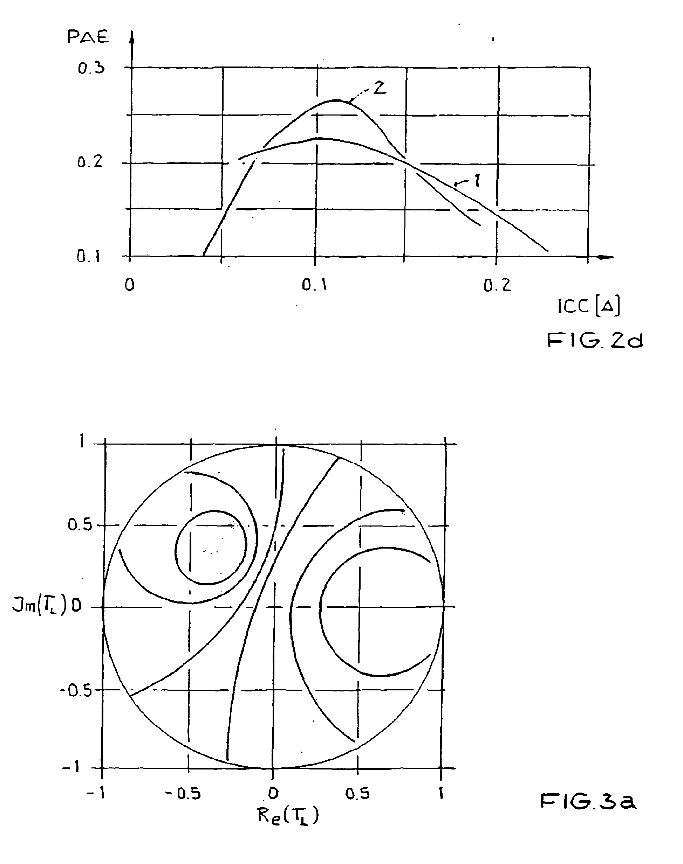

Das erfindungsgemäße Verfahren zur Unterstützung beim Schaltungsdesign wird nachfolgend anhand zweier praktischer Beispiele und unter Zuhilfenahme mehrerer Figuren erläutert werden. Bei beiden Beispielen ist die Aufgabe die Effizienz der Leistungsverstärkung (PAE) eines linearen 5 GHz Ausgangstreibers mit einer Betriebsspannung von 3.4 V für den mobilen wireless-LAN Betrieb zu optimieren. Das erste Beispiel behandelt eine single-ended-Topologie (Fig. 1a, b, c) zunächst noch ohne die erfindungswesentlichen Verfahrensschritte. Im zweiten Beispiel wird anhand einer differentiellen Schaltungstopologie das erfindungsgemäße Verfahren erläutert (Fig. 2 bis Fig. 4).

Dabei zeigen

| | |
|---|---|
| Fig. 1a | einen ersten, nicht-symmetrischen Verstärkerschaltkreis, |
| Fig. 1b | Kurven von Parametern des ersten Verstärkerschaltkreises, |
| Fig. 1c | ein Ausgangskennlinienfeld des ersten Verstärkerschaltkreises, |
| Fig. 2a | einen zweiten, symmetrischen Verstärkerschaltkreis, |
| Fig. 2b und 2c | Ausgangskennlinienfelder des zweiten Verstärkerschaltkreises, |
| Fig. 2d | Verläufe der Effizienz der Leistungsverstärkung über dem Kollektorstrom, |
| Fig. 3a und 3b | graphische Darstellungen elektrischer Parameter des zweiten Verstärkerschaltkreises, und |
| Fig. 4 | ein Ausgangskennlinienfeld eines aktiven Bauelementes. |

"Mobiler Betrieb" bedeutet insbesondere eine veränderliche Umgebung. Insbesondere metallische Gegenstände in der Nähe einer Sendeantenne können die Antennenanpassung empfindlich stören. Hierbei verschiebt sich der Reflektionsfaktor der Antenne. Um in einer veränderlichen Umgebung den stabilen Betrieb der Sendeeinheit gewährleisten zu können, ist es erforderlich, dass der Ausgangtreiber unabhängig von der Last im passiven Bereich des Smith-Charts arbeitet. In diesem Falle spricht man von unbedingter Stabilität. Als Kenngröße für unbedingte Stabilität dient gemeinhin der Rolletsche Stabilitätsfaktor k; nimmt er in einem Arbeitspunkt und zu einer gegebenen Frequenz einen Wert größer als 1 an, so ist das betrachtete Bauelement in diesem Arbeitspunkt und bei dieser Frequenz unbedingt stabil.

Ist eine Ausgangsstufe bei der betrachteten Frequenz unbedingt stabil, bei einer anderen Frequenz und gegebenen Abschlussbedingungen jedoch schwingfähig, so reichen infinitesimale Störungen, wie beispielsweise Rauschen, mit einem Frequenzanteil bei der anderen Frequenz, um die Ausgangsstufe bei der anderen Frequenz zum Schwingen zu bringen. Um einen stabilen Betrieb unter allen Umständen gewährleisten zu können, ist unbedingte Stabilität im Arbeitspunkt und für alle Frequenzen zu fordern. Um die Erfüllung dieser Forderung zu untersuchen, wird im Allgemeinen der Frequenzgang des Rolletschen Stabilitätsfaktors k im Arbeitspunkt grafisch dargestellt.

Fig. 1a zeigt einen Schaltkreis, wie er für Hochfrequenzanwendungen geeignet ist: Es ist ein nicht-symmetrischer (single-ended) Ausgangtreiber für 5GHz bei einer Versorgungsspannung von 3.4 V dargestellt. Dabei dienen die Transistoren Q3 und Q8 zusammen mit der Stromquelle $I_{DC}$ und der Spannungsquelle $V_{DC}$ der Festlegung eines Arbeitspunktes, welcher durch Einstellen der Stromquelle $I_{DC}$ und der Spannungsquelle $V_{DC}$ variiert werden kann. Durch die Induktivität L5, beispielsweise einer Spule, sind diese Bauelemente für hohe Frequenzen im Bereich von 5 GHz entkoppelt.

Die Signalquelle EIN ist über eine Kapazität C1, beispielsweise einen Scheibenkondensator, mit der Basis eines Transistors Q7, eines Hochfrequenzbipolartransistors, verbunden. Eine Spannungsquelle $V_{CE}$ zur Einstellung der Kollektor-Emitterspannung ist über eine Induktivität L1 mit dem Kollektor des Transistors Q7 verbunden. Die Induktivität L1 dient ebenfalls der Entkopplung der Spannungsversorgung von der Hochfrequenz. Weiterhin ist der Kollektor des Hochfrequenzbipolartransistors Q7 über einen Kondensator C2 mit dem Ausgangsanschluss AUS verbunden. Unmittelbar mit dem Emitter des Transistors Q7 ist der eine Pol eines stabilisierenden Emitter-Vorwiderstandes R2 verbunden, dessen zweiter Pol über eine Induktivität L2 an Masse hängt. Ferner verbindet ein Rückkopplungszweig aus dem Kondensator C8 in Serie mit einem weiteren Widerstand R1 den zweiten Pol des Emitter-Vorwiderstandes R2 mit der Basis des Hochfrequenzbipolartransistors Q7.

Die maximal über dem Bauelement abfallende thermische Verlustleistung ist mit 550mW spezifiziert, mit einer ausreichenden Sicherheit wird man daher das Bauelement bei 3.4V Versorgungsspannung vorzugsweise mit einem Strom von etwa 120 mA beaufschlagen (3.4V x 120mA = 410mW = 0.75 x 550mW) .

Fig. 1 b zeigt, strichliniert, den Frequenzgang des Rolletschen Stabilitätsfaktors k im Arbeitspunkt 3.4 V / 120 mA sowie, strichpunktiert, den Gang der maximalen Leistungsverstärkung. Die maximale Leistungsverstärkung bei der Betriebsfrequenz ist durch ein Dreieck markiert. Die betrachtete Schaltung erscheint nach dieser Auftragung für alle Frequenzen unbedingt stabil zu sein.

Fig. 1 c zeigt ein Ausgangskennlinienfeld 100 der Schaltung aus Fig. 1 a, mit Darstellung der Kollektor-Emitter-Spannung ($U_{CE}$) von Transistor Q7 als Ordinate und Darstellung des Kollektorstromes ($I_C$) von Transistors Q7 als Abszisse (dünne Linien) . Ferner sind dargestellt die Örtskurve 1 maximaler über dem Bauelement abfallender Leistung und die gewünschte Betriebsspannung 3.4 V ($U_{CE0}$) nebst dem angedachten Arbeitspunkt A bei 120 mA.

Fig. 1c zeigt ein Ausgangskennlinienfeld ohne die später erst erläuterten vorteilhaften Verfahrensmerkmale. Hierzu sind, punktiert umrandet, Bereiche (MAG) näherungsweise konstanter maximaler Leistungsverstärkung bei der Betriebsfrequenz 5 GHz, sowie, strichliniert umrandet, Bereiche (k') eingezeichnet, in denen der Rolletscher Stabilitätsfaktor bei den Frequenzen 0.5 GHz bzw. 1 GHz näherungsweise gleich 1 ist.

Im Zuge der Designoptimierung der vorliegenden Schaltung kann der Darstellung aus der Fig. 1 c zunächst entnommen werden, dass der Arbeitspunkt A' mit 120 mA Kollektorstrom $I_{C0}$ im Sinne maximaler Leistungsverstärkung G gut gewählt ist. Zum Zweiten zeigt Fig. 1 c durch die Auftragung des Rolletschen Stabilitätsfaktors k' für unterschiedliche Frequenzen, dass schon geringe Schwankungen der Versorgungsspannung $V_{CE0}$ ausreichen, dass der betrachtete Schaltkreis den unbedingt stabilen Bereich verlässt.

Im zweiten Beispiel wird ein hinsichtlich der maximalen Effizienz der Leistungsverstärkung optimaler Arbeitspunkt für die in Fig. 2a gezeigte symmetrische Schaltung gesucht. Dabei dienen die Bauelemente I1, V1, Q11, Q12, L1, L2, R1, R2, Q21, Q22, V2 und I2 der Einstellung des Arbeitspunktes und werden im Folgenden nicht näher erläutert. Der symmetrische Signaleingang EIN ist über die zwei Kondensatoren C31 und C32 mit den jeweiligen Basen der beiden Hochfrequenzbipolartransistoren Q31 und Q32 verbunden. Die Kollektoranschlüsse der zweiten Hochfrequenztransistoren Q31 und Q32 sind mit dem symmetrischen Signalausgang AUS der Schaltung und weiteren Bauelementen zur Arbeitspunkteinstellung L41, L42 und V3 verbunden.

In Fig. 2b werden Parameter der Schaltung aus Fig. 2a über, waagrecht, der DC-Kollektor-Emitter-Spannung $V_{CE}$ der Transistoren Q31 und Q32 sowie, senkrecht, dem DC-Kollektorstrom dieser Transistoren, aufgetragen. Zunächst werden, punktiert, Bereiche annähernd konstanter maximaler Leistungsverstärkung MAG bei der Betriebsfrequenz 5 GHz dargestellt. Zwei benachbarte Bereiche unterscheiden sich hierbei im Mittel um 1 dB in der maximalen Leistungsverstärkung.

Darüber hinaus zeigt Fig. 2b die Verläufe einzelner, mit Hilfe eines erfindungsgemäßen Verfahrens abgeschätzter, Isohypsen der Effizienz der Leistungsverstärkung, PAE, am 1-dB-Kompressionspunkt P-$_{1dB}$.

Zuletzt sind in Fig. 2b ein PAE-optimaler Arbeitspunkt A$_{opt}$, eine PAE-optimale Lastlinie G mit Grenzen P2a und P2b eines Bereiches, in welchem die maximale Leistungsverstärkung um höchstens 3dB von ihrem Maximum abweicht, eingezeichnet.

Der Kern des erfindungsgemäßen, mit Hilfe von Mitteln der elektronischen Datenverarbeitung automatisierten Verfahrens wird nachfolgend anhand einer einfachen grafischen Implementierung dargestellt. Diese Implementierung geht aus von einem Ausgangskennlinienfeld mit eingezeichneten Isohypsen oder isohyptischen Bereichen der maximalen Leistungsverstärkung.

Bei einer einfachen Ausführungsform der erfindungsgemäßen Lösung werden in das Ausgangskennlinienfeld eine Vielzahl Geradenabschnitte eingezeichnet. Unter Zuhilfenahme der Isohypsen der maximalen Leistungsverstärkung wird entlang eines jeden dieser Geradenabschnitte ein Punkt abgeschätzt, in welchem die maximale Leistungsverstärkung ihren Höchstwert auf dem jeweiligen Geradenabschnitt annimmt. In diesem Punkt tangiert der jeweilige Geradenabschnitt eine der Isohypsen.

Nachfolgend werden, ausgehend vom Punkt höchster maximaler Leistungsverstärkung, in beide Richtungen entlang des Geradenabschnitts Strecken abgetragen, dergestalt, dass die Endpunkte der Strecken auf Isohypsen zu einer um 3dB geringeren maximalen Leistungsverstärkung liegen als dem höchsten Wert der maximalen Leistungsverstärkung.

In einer Ausführungsform des Verfahrens wird der Mittelpunkt zwischen diesen beiden Endpunkten als Schätzwert für einen Arbeitspunkt herangezogen, welcher entlang des jeweiligen Geradenabschnitts die höchste Effizienz der Leistungsverstärkung erlaubt, und die höchste Effizienz der Leistungsverstärkung abgeschätzt aus einer Auslenkung um den Mittelpunkt bis zu den beiden Endpunkten hin.

In einer weiteren Ausführungsform des Verfahrens wird der Punkt höchster maximaler Leistungsverstärkung als Schätzwert für einen Arbeitspunkt herangezogen, welcher entlang des jeweiligen Geradenabschnitts die höchste Effizienz der Leistungsverstärkung erlaubt, und die höchste Effizienz der Leistungsverstärkung abgeschätzt aus einer Auslenkung um den Mittelpunkt bis zu demjenigen der beiden Endpunkte hin, welcher dem abgeschätzten Arbeitspunkt näher liegt.

In der Hochfrequenzelektronik hat sich als relativ einfach zu fassendes Maß für die Größe des linearen Verstärkungsbereiches der 1-dB-Kompressionspunkt P-$_{1dB}$ eingebürgert. Dies ist eine relativ grobe, jedoch pragmatische Herangehensweise an die Verzerrung durch ein Bauelement.

Im Rahmen der beiden beschriebenen grafischen Verfahren wird zunächst der Verlauf der Leistungsverstärkung entlang einer Lastlinie zunächst durch den Verlauf der maximalen Leistungsverstärkung entlang der Lastlinie angenähert: Während in einem beliebigen Arbeitspunkt für einen großen Teil der möglichen Ausgangsreflektionsfaktoren der absolute Wert der Leistungsverstärkung stark von dem maximale möglichen Wert abweicht, zeigt das Experiment, dass der relative Verlauf der lokalen Leistungsverstärkung entlang einer Kurve im Ausgangskennlinienfeld nur wenig vom Ausgangsreflektionsfaktor abhängt. Um Aussagen über die Änderung der Leistungsverstärkung entlang einer Kurve im Ausgangskennlinienfeld zu gewinnen, wird diese durch die Änderung der maximalen Leistungsverstärkung angenähert.

Im Rahmen der beiden beschriebenen grafischen Verfahren wird weiters der tatsächliche Verlauf einer Lastlinie durch einen Geradenabschnitt angenähert.

Im Rahmen der beiden beschriebenen grafischen Verfahren zur Ermittlung von Arbeitspunkten maximaler Effizienz der Leistungsverstärkung wird zum Dritten der 1-dB-Kompressionspunkt abgeschätzt, indem davon ausgegangen wird, dass die integrale Leistungsverstärkung um etwa 1dB abgefallen ist, wenn der lokale Wert der maximalen Leistungsverstärkung entlang der genäherten Lastlinie um 3dB abgefallen ist.

Häufig erfordert die Auslegung elektronischer Schaltkreise eine Abwägung zwischen unterschiedlichen, gleichzeitig zu optimierenden Zielgrößen. Das vorliegende Verfahren wird zu diesem Zwecke beispielsweise Anwendung finden auf die Optimierung von Großsignal-Kenngrößen, welche unterschiedliche Zielgrößen gewichtet enthalten. In einer Weiterbildung des Verfahrens zur Unterstützung bei der Auffindung von optimalen Großsignal-Arbeitspunkten unter gleichzeitiger Optimierung unterschiedlicher Zielgrößen werden dagegen nach Abschätzung von, eine primäre Zielgröße entlang einzelner Lastlinien optimierenden, Arbeitspunkten neben Isohypsen der primären Zielgröße auch Verläufe anderer Schaltungsparameter über den gefundenen optimierende Arbeitspunkten aufgetragen, beispielsweise in Form von Isohypsen.

Eine solche zumindest näherungsweise Ermittlung ist einer numerisch exakten Berechnung nach dem Stand der Technik, wie sie beispielsweise durch Harmonic-Balance-Verfahren ermöglicht wird, insbesondere im Rechenaufwand um Vieles überlegen.

Fig. 2c zeigt ein Beispiel einer solchen Auftragung für das Beispiel der Schaltung aus Fig. 2a. Waagrecht ist die DC-Kollektor-Emitter-Spannung $V_{CE}$ der Transistoren Q31 und Q32 und senkrecht der DGKollektorstrom aufgetragen. Scharen von Isohypsen der erzielbaren Effizienz der Leistungsverstärkung PAE sind als durchgezogene Linien dargestellt, Isohypsen der Ausgangsleistung $P_{AC}$ strichliniert, und, wie in Fig. 2b, isohyptische Bereiche der maximalen Leistungsverstärkung MAG punktiert begrenzt.

Als weitere Ausführungsbeispiele der Erfindung werden nachfolgend zwei Algorithmen zur automatisierten Abschätzung von Arbeitspunkten maximaler Effizienz der Leistungsverstärkung angegeben.

Erster Algorithmus:

Im Folgenden wird ein Algorithmus zur Auffindung optimaler Arbeitspunkte für eine optimale Effizienz der Leistungsverstärkung PAE in der Implementierung in Form eines den Entwurf elektronischer Schaltungen unterstützenden Programms für eine Einrichtung der elektronischen Datenverarbeitung anhand des Schaltungsbeispiels aus Fig. 2a beschrieben.

Ausgehend von der in Fig. 2a dargestellten Schaltung wird ein Ausgangskennlinienfeld aufgenommen, das den gesamten zulässigen Strom-Spannungs-Bereich überdeckt. In dem hier exemplarisch durchgerechneten Beispiel umfasst das Ausgangskennlinienfeld 101 äquidistante Werte des Steuerstromes I1 von 0 mA bis 800 mA, und 161 äquidistante Werte der Spannung $V_{CE}$ von 0 V bis 8 V. An jedem dieser Strom-Spannungs-Punkte werden die S-Parameter für ein ausreichend dichtes Frequenzfeld ausgegeben, im betrachteten Beispiel bei den Frequenzen 100, 200 500 MHz und 1, 2, 5, 10, 20 GHz.

Ausgangskennlinien- und S-Parameter-Feld lassen sich beispielsweise aus Modellen oder Messungen gewinnen. Ausgehend vom S-Parameter-Feld lässt sich nun direkt die maximale Leistungsverstärkung G bei der gewünschten Betriebsfrequenz bestimmen. Der maximale über dem betrachteten Bereich des Ausgangskennlinienfeldes angenommene Wert der maximalen Leistungsverstärkung G bei der Betriebsfrequenz 5 GHz, nachfolgend MAGmax genannt, beträgt im betrachteten Beispiel 26.1 dB. Es lassen sich weiterhin die Orte der Punkte im Ausgangskennlinienfeld bestimmen, an denen der Betrag der maximalen Leistungsverstärkung um beispielsweise 0.5 dB kleiner ist als dieses Maximum MAGmax. Diese Punkte sind in Fig. 2b durch den inneren der Bereiche annähernd konstanter maximaler Leistungsverstärkung MAG gegeben.

Für das weitere Vorgehen ist die Kenntnis oder Festlegung von zweckdienlichen höchsten Werten für Ströme und Spannungen im Bauelement vonnöten. Der zweckdienlich höchste Wert des Stromes, nachfolgend IBBmax genannt, wird im Beispiel als höchster unter den Stromwerten an Punkten im Ausgangskennlinienfeld, an denen der Betrag der maximalen Leistungsverstärkung um 0.5 dB kleiner ist als das Maximum MAGmax, zu 900 mA gewählt, der vorteilhafterweise höchste Wert der Spannung, nachfolgend als VCEmax bezeichnet, als die Durchbruchsspannung bei verschwindender Stromdichte, 8 V.

Damit der nachfolgend beschriebene Algorithmus ohne Einsatz von Geist sinnvolle Abschätzungen für die PAE-optimale Betriebsbedingungen für den in Fig. 2a dargestellten Schaltkreis auffindet, ist ferner vorteilhaft, dass das Ausgangskennlinienfeld für Strom-Spannungs-Werte bis in etwa zu einem Punkt (VCEmax ¦ 2*IBBmax) hin aufgenommen worden ist. Im betrachteten Beispiel ist dies erfüllt, widrigenfalls müssen Ausgangskennlinien- und S-Parameterfelder für einen angepassten Strombereich aufgenommen und die bisher beschriebenen Schritte wiederholt werden.

Zur näherungsweisen automatischen Bestimmung PAE-optimaler Arbeitspunkte wird weiterhin eine, im betrachteten Beispiel gerade, Linie LL zwischen den Punkten (0 ¦ 0) und (VCEmax ¦ IBBmax) in eine zweckdienlich gewählte erste Anzahl N1 von äquidistanten Arbeitspunkten A1 bis AN1 unterteilt. Die Größe der zweckdienlichen ersten Anzahl N1 bestimmt dabei die Glätte und die Ortsauflösung der zu bestimmenden Isohypsen der Effizienz der Leistungsverstärkung PAE über dem Ausgangskennlinienfeld mit. Ein meist zielführender Wert der zweckdienlichen ersten Anzahl N1 ist beispielsweise ein Wert von 100.

Zur näherungsweisen automatischen Bestimmung PAE-optimaler Arbeitspunkte wird ferner eine zweckdienliche zweite Anzahl N2 gewählt. Die zweckdienliche zweite Anzahl N2 ist gleich einer Anzahl von Punkten im passiven Bereich der Last-Reflektionsfaktorebene, über die ein erster Auswerteschritt im Rahmen des beschriebenen Algorithmus erstreckt. Ein meist zielführender Wert der zweckdienlichen zweiten Anzahl N2 ist beispielsweise ein Wert von 300. Im passiven Bereich der Last-Reflektionsfaktorebene werden nun annähernd gleichmäßig eine Anzahl von Lastreflektionsfaktoren R1 bis RN2 gewählt, welche Anzahl gleich der zweckdienlichen zweiten Anzahl N2 ist, zu welchem Zwecke beispielsweise folgende Festschreibung dienen kann:

Ein Punkt Rn im passiven Bereich der Last-Reflektionsfaktorebene mit Ordnungszahl n, wobei die Ordnungszahl n größer oder gleich 1 und kleiner oder gleich der zweckdienlichen zweiten Anzahl N2 ist, wird gegeben durch den Ausdruck:

$$Rn = \sqrt{\frac{n}{N2}} \exp\left(\sqrt{-4p \cdot n}\right)$$

Zu jedem der Lastreflektionsfaktoren R1 bis RN2 und zu jedem der Arbeitspunkte A1 bis AN1 wird nun das nachfolgend beschriebene Näherungsverfahren zur Abschätzung der zu gegebenem Lastreflektionsfaktor auf einer durch den gegebenen Arbeitspunkt gehenden Lastlinie erzielbaren Effizienz der Leistungsverstärkung PAE angewandt:

Es wird eine Ortskurve LA im Ausgangskennlinienfeld gewählt als Lastgerade LA zum resistiven Anteil der zum betrachteten Lastreflektionsfaktor gehörenden Last durch den betrachteten Arbeitspunkt. Zum betrachteten Lastreflektionsfaktor wird eine problemangepasste Eingangsimpedanz gewählt. Im Falle eines Leistungsverstärkers kann diese beispielsweise einem Quellenreflektionsfaktor entsprechen, welcher gleich dem komplex Konjugierten des bei dem betrachteten Lastreflektionsfaktor gesehenen Eingangsreflektionsfaktors ist.

Entlang dieser Ortskurve PA werden, ausreichend fein ortsaufgelöst und ausgehend von, beziehungsweise vermittelnd zwischen, Punkten des Ausgangskennlinien- sowie S-Parameterfeldes, die zu den betrachteten Last-und Quellenreflektionsfaktoren gehörigen Leistungsverstärkungen aufgetragen. Die so gefundene Kurve "Leistungsverstärkung über Spannung und Strom entlang der Ortskurve" LA wird nachfolgend "Gainverlauf" genannt.

Es wird der Ort des Maximums des Gainverlaufes aufgesucht (sollte er in einem vorrangig interessierenden Strom-pannungs-Bereich nicht eindeutig sein, wird der Gainverlauf verworfen und ein anderes Paar von Lastreflektionsfaktor und Arbeitspunkt betrachtet), sowie alle Orte P1 bis Pn entlang des Gainverlaufes, an denen die Leistungsverstärkung einen festen Bruchteil des Maximums des Gainverlaufes beträgt. Zweckdienlich zur Bestimmung des Maßes "Kompressionspunkt $P_{-1dB}$" der erzielbaren linearen Ausgangsleistung ist beispielsweise ein Bruchteil von 0.5 des Maximums des Gainverlaufs, bzw. 3 dB weniger als das Maximum des Gainverlaufes.

Ferner wird untersucht, ob zwei eindeutig bestimmte Punkte Pa und Pb unter den Punkten P1 bis Pn existieren, welche erfüllen:

- der Punkt Pa ist unter denjenigen der Punkte P1 bis Pn, deren Spannungswerte kleiner als der Spannungswert am Ort des Maximums des Gainverlaufes ist, derjenige mit dem höchsten Spannungswert,

- der Punkt Pb ist unter denjenigen der Punkte P1 bis Pn, deren Spannungswerte größer als der Spannungswert am Ort des Maximums des Gainverlaufes ist, derjenige mit dem niedrigsten Spannungswert,

in welchem Falle der Mittelpunkt der beiden Punkte Pa und Pb als Schätzwert für einen zum betrachteten Reflektionsfaktor sowie zum betrachteten Arbeitspunkt gehörigen PAE-optimalen Arbeitspunkt herangezogen, widrigenfalls jedoch eine neue Lastgerade herangezogen, wird.

Als Schätzwert für die Ausgangsleistung im derart gefundenen PAE-optimalen Arbeitspunkt wird ein Achtel des Produktes der Differenzen der Strom- und der Spannungswerte an den Punkten Pa und Pb herangezogen, als Schätzwert für die Ruhe-Leistungsaufnahme ein Viertel des Produktes der Summen der Strom- und Spannungswerte an den Punkten Pa und Pb, sowie als Schätzwert für die erzielbare Effizienz der Leistungsverstärkung PAE der Quotient aus der Ausgangsleistung und der Ruhe-Leistungsaufnahme, wobei $I_x$ den Strom

und $U_x$ die Spannung im Punkt Px bezeichnen:

$$PAE \approx \frac{1}{2} \left| \frac{(I_a - I_b)(U_a - U_b)}{(I_a + I_b)(U_a + U_b)} \right|.$$

Zu jedem der Lastreflektionsfaktoren R1 bis RN2 wird mit Hilfe des so beschriebenen Näherungsverfahrens zur Abschätzung der zu gegebenem Lastreflektionsfaktor erzielbaren Effizienz der Leistungsverstärkung PAE zu jedem der Arbeitspunkte A1 bis AN1 die Effizienz der Leistungsverstärkung PAE abgeschätzt, sowie ein geeignetes statistisches Maß für einen repräsentativen Wert der so erhaltenen Schätzwerte für die Effizienz der Leistungsverstärkung PAE zu dem betrachteten Lastreflektionsfaktor gebildet.

Als repräsentativer Wert kann, namentlich bei kleinen Werten der zweckdienlichen ersten Anzahl N1, beispielsweise N1=20, der Median der erhaltenen Schätzwerte dienen, jedoch auch, namentlich bei größeren Werten der zweckdienlichen ersten Anzahl N1, beispielsweise N1=100, der Mittelwert der oberen 25 % der Schätzwerte.

In einem nächsten Schritt wird, mit Hilfe der dergestalt bestimmten repräsentativen Werte für die Abschätzungen der Effizienz der Leistungsverstärkung PAE in Abhängigkeit vom Lastreflektionsfaktor, ein PAE-optimaler Lastreflektionsfaktor abgeschätzt. Zu diesem Zweck kann beispielsweise der Mittelwert über alle Lastreflektionsfaktoren gebildet werden, an denen die repräsentativen Werte mindestens 85 % des maximalen repräsentativen Wertes über die Lastreflektionsfaktoren R1 bis RN2 betragen.

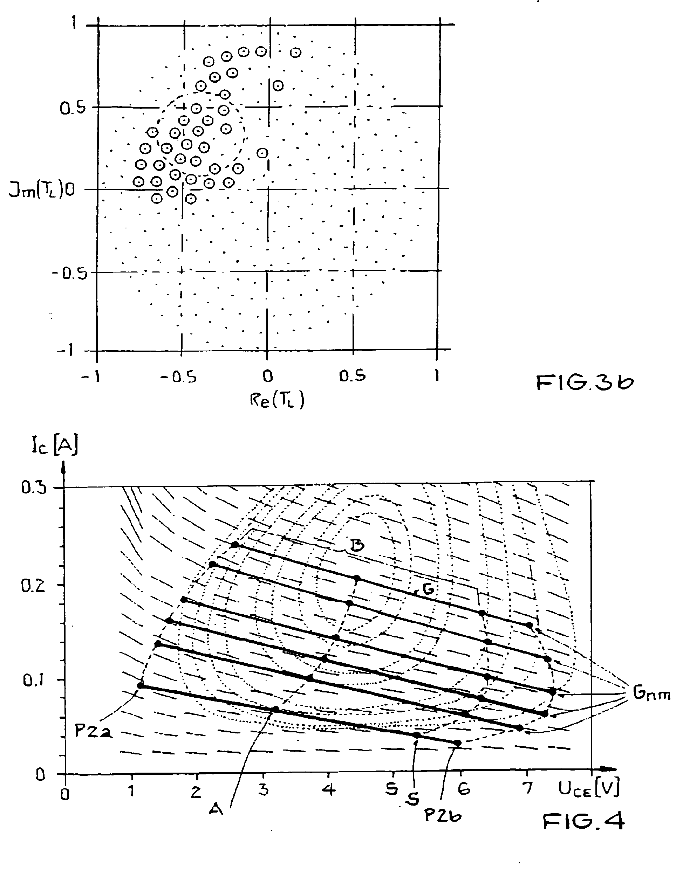

Fig. 3a skizziert schematisch den Verlauf der gefundenen repräsentativen Werte der Leistungsverstärkung PAE für die betrachteten Lastreflektionsfaktoren R1 bis RN2 in Form von Höhenlinien, Fig. 3b zeigt, für eine zweckdienliche zweite Anzahl N2 von 300, die Lage der betrachteten Lastreflektionsfaktoren in der Lastreflektionsfaktorebene als Punkte, Lastreflektionsfaktoren, an denen die repräsentativen Werte mehr als 85 % des maximalen repräsentativem Wertes für die Abschätzungen der Effizienz der Leistungsverstärkung PAE betragen, als kleine Kreise, sowie den 1-s-Bereich für den genannten Mittelwert von Lastreflektionsfaktoren schraffiert umrandet.

Die zu dem gefundenen Mittelwert der Lastreflektionsfaktoren gehörige Last stellt als erste Näherung $R_{opt,1}$ an eine die Effizienz der Leistungsverstärkung PAE optimierende Last ein erstes Ergebnis des erfindungsgemäßen Algorithmus dar.

Aufgrund der Näherung der echten Lastlinien zu den gegebenen Lastreflektionsfaktoren durch Teile von Widerstandsgeraden wird die Abhängigkeit der erzielbaren Effizienz der Leistungsverstärkung PAE vom Imaginärteil der Lastreflektionsfaktoren hierbei weniger gut angenähert werden als die Anhängigkeit vom Realteil der Lastreflektionsfaktoren. Eine genauere Abschätzung des die Effizienz der Leistungsverstärkung PAE optimierenden Realteiles des Lastreflektionsfaktors erscheint daher in Maßen förderlicher als eine genauere Abschätzung des Imaginärteiles.

In einem weiteren Verfahrensschritt wird nun, ausgehend von der gefundenen ersten Näherung $R_{opt,1}$, ein zweite Näherung an die die Effizienz der Leistungsverstärkung PAE optimierende Last berechnet.

Zu diesem Zwecke wird das Näherungsverfahren zur Abschätzung der zu gegebenem Lastreflektionsfaktor erzielbaren Effizienz der Leistungsverstärkung PAE angewandt auf die zweckdienliche erste Anzahl N1 von Arbeitspunkten A1 bis AN1 sowie die Elemente eines zweiten Satzes von Lastreflektionsfaktoren. Der zweite Satz von Lastreflektionsfaktoren umfasst hierbei eine zweckdienliche dritte Anzahl N3 von Lastreflektionsfaktoren S1 bis SN3. Die zu einem beliebigen Lastreflektionsfaktor Sx mit Ordnungsnummer x aus dem zweiten Satz von Lastreflektionsfaktoren S1 bis SN3 gehörige Last weist denselben Imaginärteil auf wie die erste Näherung $R_{opt,1}$ an eine die Effizienz der Leistungsverstärkung PAE optimierende Last sowie einen Realteil, welcher zwischen beispielsweise dem halben und dem doppelten Wert des Realteiles der ersten Näherung $R_{opt,1}$ vermittelt.

Eine mögliche Vorschreibung für die Art der Vermittlung ist beispielsweise eine logarithmische Unterteilung der Strecke zwischen dem halben und dem doppelten Wert des Realteiles der ersten Näherung Ropt,1,

$$\frac{Re(R_{opt,1})}{2} 4^{\frac{x}{N3}}.$$

In einem letzten Schritt werden zunächst die mit Hilfe des Näherungsverfahrens zur Abschätzung der zu gegebenem Lastreflektionsfaktor erzielbaren Effizienz der Leistungsverstärkung PAE gewonnenen Schätzwerte für die zum zweiten Satz von Lastreflektionsfaktoren sowie den betrachteten Arbeitspunkten gehörigen Abschätzungen für die erzielbaren Effizienzen der Leistungsverstärkung PAE über die zugehörigen abgeschätzten PAE-optimalen Arbeitspunkte in das Ausgangskennlinienfeld eingetragen, geeignet geglättet und geeignet in Klassen eingeteilt:

Fig. 2d zeigt, aufgetragen über dem Kollektorstrom, die erzielbare Effizienz der Leistungsverstärkung PAE für den Schaltkreis aus Fig. 2a bei Werten der Versorgungsspannung $V_{CE}$ von 3.3 bis 3.6 V. Kurvenverlauf 1 zeigt hierbei die Abschätzung nach einem erfindungsgemäßen Verfahren, Kurvenverlauf 2 die numerisch exakte Simulationen mit Hilfe eines transienten Simulationsprogramms für die nämlichen Arbeitspunkte. Wie ersichtlich, wird die optimale Stromdichte durch das Näherungsverfahren hinreichend gut reproduziert.

Das erfindungsgemäße Verfahren nähert den Verlauf der echten" Lastkennlinie zu einer "echten" Last an durch eine Lastgerade durch den Arbeitspunkt mit einer Steigung, welche dem Realteil der "echten" Last entspricht. Diese Näherung ist zumindest beim Design verzerrungsarmer Verstärker ausreichend gut erfüllt.

Des Weiteren wird der Verlauf der "echten" Verstärkung entlang der "echten" Lastlinie ersetzt durch einen Verlauf der Kleinsignalverstärkung entlang der Lastgeraden. Die "echte" Verstärkung zu einer gegebenen Auslenkung um einen Arbeitspunkt herum ergibt sich als ein Mittelwert über die Kleinsignalverstärkungen entlang der zugehörigen Lastgeraden. Der Verlauf der Kleinsignal-Verstärkung ist maximal flach in der Umgebung des Punktes des Maximums der Kleinsignalverstärkung. Die beispielsweise zu einer Kompression der Leistungsverstärkung von - im Mittel - 1dB gehörige Aussteuerung um den Punkt des Maximums der Kleinsignalverstärkung lässt sich abschätzen mit Hilfe der Strom- und Spannungswerte entlang der Lastgeraden, bei denen die Verstärkung um beispielsweise 3dB vom Maximalwert abgesunken ist.

Auf diese Weise lassen sich auf numerisch sehr einfache Weise Näherungswerte für den 1dB-Kompressionspunkt aus den Kleinsignalparametern der betrachteten Schaltung oder des betrachteten Bauelementes beschaffen. Darüber hinaus ist die Bestimmung einer Menge von Kleinsignalparametern im Verlauf einer Anwendung des erfindungsgemäßen Verfahrens nur ein einziges Mal nötig.

Demgemäß lassen sich selbstverständlich auch andere GroßsignalParameter, insbesondere das Intermodulationsprodukt dritter Ordnung, IP3, auf elegante und numerisch effiziente Art und Weise, ausgehend von Kleinsignalparametem, abschätzen.

Mit diesem konkreten Ausführungsbeispiel ist gleichzeitig eine selbständig ablaufende Verfahrenabfolge für eine Einrichtung der elektronischen Datenverarbeitung angegeben. Dieser dient der Unterstützung bei der näherungsweisen Bestimmung der maximale Effizienz der Leistungsverstärkung, PAE, eines elektronischen Bauelementes oder Schaltkreises, dem näherungsweisen Auffinden von Arbeitspunkten eines elektronischen Bauelementes oder Schaltkreises, durch Betreiben in welchen Arbeitspunkten die erzielbare Effizienz der Leistungsverstärkung, PAE, des Bauelementes oder Schaltkreises maximiert wird, sowie der näherungsweisen Bestimmung von Abschlussimpedanzen, durch Beschaltung mit welchen Abschlussimpedanzen die Effizienz der Leistungsverstärkung, PAE, des Bauelementes oder Schaltkreises in den genannten Arbeitspunkten maximiert wird.

Ein weiterer Aspekt der vorliegenden Erfindung betrifft hiernach die Angabe einer den Entwurf elektronischer Schaltungen unterstützende Einrichtung der elektronischen. Datenverarbeitung.

Bei dem konkreten vorliegenden Ausführungsbeispiel wird ausgegangen von einer Abschätzung eines Maximalstromes, mit welchem das aktive Bauelemente oder der aktive Schaltkreis sinnvoll zu beaufschlagen ist, sowie der maximal zulässigen, über dem aktiven Bauelement oder Schaltkreis abfallenden Sperrspannung, von welcher Abschätzung aus durch das abgegebene Verfahren die den Designer unterstützenden Hilfen automatisch gewonnen werden.

Das zuvor erläuterte konkrete Ausführungsbeispiel zeigt einen Algorithmus zur Auffindung optimaler Arbeitspunkte aktiver Bauelemente für insbesondere den Einsatz in Hochfrequenzschaltungen sowie eine den Entwurf elektronischer Schaltungen unterstützende Einrichtung der elektronischen Datenverarbeitung auf.

Zweiter Algorithmus:

Wie im vorherigen Beispiel gilt es auch hier, bei gegebenen Anschlussbedingungen am Eingang eines Verstärkerschaltkreises, die Effizienz der Leistungsverstärkung zu maximieren. Zu diesem Zwecke sind ein optimaler Arbeitspunkt nebst dazugehörigen Abschlussbedingungen am Ausgang des Verstärkerschaltkreises festzulegen.

Die Vorgehensweise im diesem zweiten, besonders erläuterten Ausführungsbeispiel des erfindungsgemäßen Verfahrens wird unter Zuhilfenahme der Fig. 4 dargestellt. Fig. 4 zeigt wieder ein Ausgangskennlinienfeld der Schaltung aus Fig. 2a, bei dem waagrecht die Ausgangsspannung und senkrecht der Ausgangsstrom aufgetragen sind. Punktiert sind, wie in den vorangegangenen Ausgangskennlinienfeldern, isohyptische Bereiche der maximal erzielbaren Leistungsverstärkung dargestellt.

Eines der Kriterien, welche für einen maximalen Leistungsübertrag an die Last, und hiernach maximale Effizienz der Leistungsverstärkung, zu erfüllen sind, ist das Verschwinden der Blindleistung am Verstärkerausgang. Hierzu muss die Parallelschaltung der Ausgangsimpedanz des Verstärkers mit der Eingangsimpedanz der effektiven Last reell sein, so dass sich der Ausgang zumindest lokal auf einer ohmschen Lastgerade bewegt.

Durch die Forderung maximaler Leistungsverstärkung und eine gegebene Anpassbedingung am Eingang sind die Eingangsimpedanz der effektiven Last wie auch die Ausgangsimpedanz des Verstärkerschaltkreises festgelegt, so dass sich die lokale Steigung der Lastgeraden bestimmen lässt. Diese Steigungen in den möglichen Arbeitspunkten stellen, zumindest bei ausreichend kleinen Auslenkungen um die Ruhelage, ein Tangentenfeld an die leistungsangepassten Lastlinien dar. Als eine erste Bedingung an eine mögliche, unter Leistungsanpassung die Effizienz der Leistungsverstärkung optimierende Lastlinie ergibt sich hieraus, dass die Steigung der Lastlinie im Arbeitspunkt mit der Steigung des Tangentenfeldes übereinstimmen muss.

Diese erste Bedingung, welche in einem Ausführungsbeispiel des erfindungsgemäßen Verfahrens vorteilhaft ausgenutzt wird, wird in der vorliegenden Schutzschrift zum ersten Mal veröffentlicht; das Tangentenfeld ist im Ausgangsdiagramm der Fig. 4 mit Hilfe dünner Geradenstücke dargestellt.

Unter den Betriebsbedingungen maximaler Effizienz der Leistungsverstärkung sind Betriebsbedingungen besonders ausgezeichnet, welche die Verzerrung eines Schaltkreises minimieren. Ein, ebenfalls in der vorliegenden Schutzschrift erstmalig vorgestelltes, Kriterium für derartige Betriebsbedingungen ist das Verschwinden der ersten Ableitung des Verlaufes der Kleinsignal-Leistungsverstärkung im Arbeitspunkt. Es ergibt sich als eine zweite Bedingung an eine mögliche, die Effizienz der Leistungsverstärkung optimierende Lastlinie oder Lastlinienschar hieraus, dass die Lastlinien im Arbeitspunkt Isohypsen der maximal erzielbaren Leistungsverstärkung tangieren müssen.

Für jede Isohypse der Leistungsverstärkung existieren im einfachsten Fall lediglich zwei ausgezeichnete Arbeitspunkte, in denen sich beide Bedingungen gleichzeitig erfüllen lassen. Beispielhaft sind einzelne solcher ausgezeichneter Arbeitspunkte in Fig. 4 durch Kreisscheibchen markiert und durch eine, mit "A" bezeichnete, strichlinierte Linie miteinander verbunden. Dick durchgezogen dargestellt sind eine Vielzahl Gnm von Näherungen an die Effizienz der Leistungsverstärkung optimierende Lastlinien, beispielsweise die mit "G" gekennzeichnete Näherung, durch die ausgezeichneten Arbeitspunkte.

Als weitere ausgezeichnete Punkte entlang der näherungsweisen Lastlinien sind durch Kreisscheibchen markiert und durch je eine strichlinierte Linie (P2a, P2b) miteinander verbunden die oberen und unteren Randpunkte derjenigen Abschnitte der näherungsweisen Lastlinien, in welchen die maximal erzielbare Leistungsverstärkung um weniger als 3dB vom Maximum entlang der näherungsweisen Lastlinien abweichen.

Im, im Idealfall, verzerrungsfreien Betrieb unterscheidet sich der Energiebetrag, welcher zur Auslenkung des Schaltkreises aus einem der ausgezeichneten Arbeitspunkte in den zugehörigen oberen Randpunkt vonnöten ist, nicht von einem entsprechenden Betrag zur Auslenkung in den unteren Randpunkt. Da kraft Konstruktion die dick durchgezogenen Lastlinien in Fig. 4 einen verzerrungsarmen Betrieb gestatten, wird als weitere Näherung angenommen, eine Auslenkung um die ausgezeichneten Arbeitspunkte entlang der Lastlinien nach oben und unten erfolge symmetrisch. Die Bereiche einer jeden Lastlinie des erfindungsgemäßen Verfahrens werden in diesem zweiten Ausführungsbeispiel hiernach als größte, symmetrisch um einen jeweils ausgezeichneten Arbeitspunkt gelegene Teilmengen der Lastlinie angekommen. Sie erstrecken sich in Fig. 4 von den Randpunkten auf Linien P2a bis zu den auf der strichlinierten Linie S liegenden, durch Kreisscheibchen markierten Punkten der Lastlinien, ein solcher Teilbereich der exemplarischen Lastlinie G ist in Fig. 4 als "B" bezeichnet.

Die zu den ausgezeichneten Arbeitspunkten gehörigen Effizienzen der Leistungsverstärkung werden schließlich aus der Lage der Arbeitspunkte sowie der Ausdehnung der genannten Bereiche, beispielsweise gemäß der oben beschriebenen Weiterbildung des Verfahrens, abgeschätzt. Derjenige unter allen ausgezeichneten Arbeitspunkten, welchem auf diese Weise die höchste Effizienz der Leistungsverstärkung zugeordnet wird, wird als Schätzwert für den diese Effizienz optimierenden Arbeitspunkt angenommen. Das vorliegende Verfahren dieses Ausführungsbeispiels erlaubt auf einfache Weise eine näherungsweise Bestimmung der optimalen Betriebsbedingungen unter allen Arbeitspunkten und Anschlussbedingungen.

**Patentansprüche**

1. Computerimplementiertes Verfahren zum Entwurf einer Schaltung mit einem aktiven Bauelement, das durch Bauelemente der Schaltung in einem Arbeitspunkt eingestellt ist, indem

   - eine Vielzahl (Gnm) von Lastlinien (G) des aktiven Bauelements näherungsweise ermittelt wird,
   - ein Verlauf einer Kleinsignal-Kenngröße entlang einer jeden Lastlinie (G) näherungsweise bestimmt wird, wobei die Kleinsignal-Kenngröße eine Verstärkung oder ein S-Parameter oder eine Rauschzahl oder ein effektiver Eingangsreflektionsfaktor oder ein effektiver Ausgangsreflektionsfaktor oder ein effektiver Ausgangswiderstand oder ein Rollet'scher Stabilitätsfaktor ist,
   - ein Bereich (B) einer jeden Lastlinie (G) als eine Teilmenge der Lastlinie (G) bestimmt wird, wobei der Bereich (B) durch eine charakteristische, von der Kleinsignal-Kenngröße abhängende Eigenschaft ausgezeichnet ist, und
   - zur Bestimmung des Arbeitspunktes des aktiven Bauelementes für eine optimale Großsignal-Kenngröße ein der Lastlinie (G) zugeordneter Wert einer Großsignal-Kenngröße aus dem Verlauf der Kleinsignal-Kenngröße innerhalb des Bereiches (B) näherungsweise ermittelt wird, wobei die Großsignal-Kenngröße eine Leistungsverstärkung oder ein Intermodulationsprodukt der Ordnung n oder eine harmonische Verzerrung n-ter Ordnung oder ein Klirrfaktor oder eine Effizienz der Leistungsverstärkung oder eine Rauschzahl oder ein Kompressionspunkt oder eine Kompressionsleistung oder eine Kompression der Leistungsverstärkung oder ein Durchschnitt der Kleinsignal-Kenngröße oder ein Integral der Kleinsignal-Kenngröße ist.

2. Verfahren nach Anspruch 1, **dadurch gekennzeichnet, dass** der Bereich (B) einer jeden Lastlinie (G) in Abhängigkeit von einem signifikanten Wert bestimmt wird.

3. Verfahren nach Anspruch 2, **dadurch gekennzeichnet, dass** als Bereich (B) diejenige Teilmenge der Lastlinie (G) bestimmt wird, in welcher der Wert der Kleinsignal-Kenngröße um nicht mehr als einen bestimmten Faktor von einem lokalen Extremum abweicht.

4. Verfahren nach einem der vorhergehenden Ansprüche, **dadurch gekennzeichnet, dass** ein Arbeitspunkt (A) innerhalb des Bereiches (B) ermittelt wird und der ermittelte Wert der Großsignal-Kenngröße dem ermittelten Arbeitspunkt (A) zugeordnet wird.

5. Verfahren nach einem der vorhergehenden Ansprüche, **dadurch gekennzeichnet, dass** zur Ermittlung der Vielzahl (Gnm) von Lastlinien (G) eine erste Menge, enthaltend eine erste Anzahl von Stütz-Arbeitspunkten, gewählt und jedem Stütz-Arbeitspunkt eine zweite Menge, enthaltend eine zweite Anzahl von Lastlinien, zugeordnet wird.

6. Verfahren nach Anspruch 5, **dadurch gekennzeichnet, dass** zur Ermittlung der Vielzahl (Gnm) von Lastlinien (G)

   - in jedem Stütz-Arbeitspunkt eine effektive Ausgangsimpedanz zu einer gegebenen Anpassbedingung am Eingang ermittelt wird, und/oder
   - in jedem Stütz-Arbeitspunkt eine Geradensteigung ermittelt wird, sowie eine Lastlinie (G) als Gerade mit der ermittelten Geradensteigung durch den Stütz-Arbeitspunkt gewählt wird, und
   - jeder Lastlinie (G) als Lastimpedanz das komplex Konjugierte der effektiven Ausgangsimpedanz zugeordnet wird.

7. Verfahren nach einem der vorhergehenden Ansprüche, **dadurch gekennzeichnet, dass** die Vielzahl (Gnm) von Lastlinien (G) ermittelt, wird indem

   - eine erste Menge von Stütz-Arbeitspunkten bestimmt wird,
   - in jedem Stütz-Arbeitspunkt eine effektive Ausgangsimpedanz zu einer gegebenen Anpassbedingung am Eingang ermittelt wird,
   - in jedem Stütz-Arbeitspunkt eine Geradensteigung ermittelt wird als ein Absolutquadrat der effektiven Ausgangsimpedanz, geteilt durch zweimal den Realteil der effektiven Ausgangsimpedanz ,
   - in jedem Stütz-Arbeitspunkt eine variierte Geradensteigung ermittelt wird, indem selbstkonsistent eine Lastimpedanz derart bestimmt wird, dass eine Parallelschaltung bestehend aus

   - erstens, der effektiven Ausgangsimpedanz des aktiven Bauelementes im Stütz-Arbeitspunkt bei gegebener Anpassbedingung am Eingang des aktiven Bauelementes, sowie
   - zweitens, der Lastimpedanz,

   einen reellen Wert gleich der variierten Geradensteigung aufweist,
   - sowie eine Lastlinie als Gerade mit der variierten Geradensteigung durch den Stütz-Arbeitspunkt gewählt wird, und
   - jeder Lastlinie (G) als Ausgangsimpedanz die selbstkonsistent bestimmte Lastimpedanz zugeordnet wird.

8. Verfahren nach Anspruch 7, **dadurch gekennzeichnet, dass** die Variation der Geradensteigung dergestalt erfolgt, dass als variierte Geradensteigung diejenige Geradensteigung gewählt wird, bei welcher der Bereich (B) die größte Ausdehnung hat.

9. Verfahren nach einem der vorhergehenden Ansprüche, **dadurch gekennzeichnet, dass** die Kleinsignal-Kenngröße die sich entlang der Lastlinie (G) ergebende Leistungsverstärkung ist, wobei Eingangs-und/oder Ausgangsimpedanzen im Stütz-Arbeitspunkt zumindest eine der Bedingungen erfüllen:

   - für die Ein- und/oder Ausgangsimpedanzen ist die erzielbare Leistungsverstärkung maximiert,
   - für die Ein- und/oder Ausgangsimpedanzen ist die stabil erzielbare Leistungsverstärkung maximiert,
   - für die Ein- und/oder Ausgangsimpedanzen ist die erzielbare Leistungsverstärkung bei Reflektionsfreiheit am Eingang maximiert,
   - für die Ein- und/oder Ausgangsimpedanzen ist die stabil erzielbare Leistungsverstärkung bei Reflektionsfreiheit am Eingang maximiert,
   - für die Ein- und/oder Ausgangsimpedanzen ist die erzielbare Leistungsverstärkung unter Minimierung der Rauschzahl maximiert,
   - für die Ein- und/oder Ausgangsimpedanzen ist die stabil erzielbare Leistungsverstärkung unter Minimierung der Rauschzahl maximiert.

10. Verfahren nach einem der vorhergehenden Ansprüche, **dadurch gekennzeichnet dass** zumindest ein ermittelter Wert der Großsignal-Kenngröße über der Spannung und dem Strom in dem zugeordneten Arbeitspunkt (A) in Form von Isohypsen der ermittelten Werte der Großsignal-Kenngröße bezüglich der Arbeitspunkte (A) graphisch dargestellt wird.

**11.** Verfahren nach einem der vorhergehenden Ansprüche, **dadurch gekennzeichnet, dass** ein Paar von Quell- und Lastimpedanzen bestimmt wird, wobei bei der Bestimmung näherungsweise die Effizienz der Leistungsverstärkung für einen näherungsweise ermittelten Arbeitspunkt (A) optimiert ist.

**12.** Verfahren zumindest nach Anspruch 5, **dadurch gekennzeichnet, dass** die erste Menge von Stütz Arbeitspunkten gebildet wird gemäß der Vorschrift:

- Wahl einer ersten Anzahl,
- Wahl eines ersten Punktes,
- Wahl eines zweiten Punktes im Ausgangskennlinienfeld des betrachteten Bauelementes oder Verstärkerschaltkreises,
- Wahl einer Strecke zwischen dem ersten Punkt und dem zweiten Punkt im Ausgangskennlinienfeld,
- Unterteilung der Strecke in eine erste Anzahl von ersten Punkten, und
- Wahl der Gesamtheit der ersten Punkte als erste Menge von Stützarbeitspunkten.

**13.** Verfahren nach Anspruch 12, **dadurch gekennzeichnet, dass** die zweite Menge von Lastimpedanzen gebildet wird gemäß der Vorschrift:

- Wahl einer zweiten Anzahl,
- Wahl einer zweiten Anzahl von Lastreflektionsfaktoren,
- Bestimmen der zu einem Lastreflektionsfaktor aus der zweiten Anzahl von Lastreflektionsfaktoren gehörigen Lastimpedanz, und
- Wahl der Gesamtheit der zweiten Anzahl der zu einem der Lastreflektionsfaktoren gehörigen Lastimpedanzen als zweite Menge von Lastimpedanzen.

**14.** Verfahren nach Anspruch 13, **dadurch gekennzeichnet, dass** die Wahl der Menge von ohmschen Lastlinien (G) durch den Arbeitspunkt

- bezüglich des ohmschen Anteils einer beliebigen aus der zweiten Anzahl von Lastreflektionsfaktoren sowie
- bezüglich einer bei dem gegebenen Arbeitspunkt und der gegebenen Lastimpedanz zweckdienlichen Eingangsimpedanz

erfolgt.

**15.** Verfahren nach einem der vorhergehenden Ansprüche, **gekennzeichnet durch**

- eine Wahl einer bei der betrachteten Lastimpedanz und dem betrachteten Arbeitspunkt zweckdienlichen Eingangsimpedanz als derjenigen Eingangsimpedanz, welche einem Quellenreflektionsfaktor entspricht, der das komplex Konjugierte des bei der betrachteten Lastimpedanz und dem betrachteten Arbeitspunkt am Eingang des aktiven Bauelementes oder Verstärkerschaltkreises gesehenen Eingangsreflektionsfaktors darstellt, und/oder-

- eine Wahl einer bei der betrachteten Lastimpedanz und dem betrachteten Arbeitspunkt zweckdienlichen Eingangsimpedanz als derjenigen Eingangsimpedanz, welche einem Quellenreflektionsfaktor entspricht, der gleich dem bei der betrachteten Lastimpedanz und dem betrachteten Arbeitspunkt am Eingang des aktiven Bauelementes oder Verstärkerschaltkreises gesehenen Eingangsreflektionsfaktors ist, und/oder

- eine Wahl einer bei der betrachteten Lastimpedanz und dem betrachteten Arbeitspunkt zweckdienlichen Eingangsimpedanz als derjenigen Eingangsimpedanz, bei welcher die Rauschzahl des aktiven Bauelementes oder Verstärkerschaltkreises minimiert ist.

**16.** Verfahren nach einem der vorhergehenden Ansprüche, **gekennzeichnet durch** eine Wahl der zweiten Anzahl (N2) von Lastreflektionsfaktoren dergestalt, dass ein Lastreflektionsfaktor (Rn) mit einer Ordnungsnummer (n) als Produkt aus

- erstens der Wurzel aus dem Quotienten der Ordnungsnummer (n) und der zweiten Anzahl (N2) und
- zweitens der zur Basis der Euler'schen Zahl e exponentierten Wurzel aus dem Negativen des Produktes von viermal der Kreiszahl $\pi$ mit der Ordnungsnummer (n) ,
- für jede natürliche Zahl kleiner als die zweite Anzahl (N2) oder gleich der zweiten Anzahl (N2) als Ordnungsnummer,

gewählt wird.

**17.** Verfahren nach einem der vorhergehenden Ansprüche, **dadurch gekennzeichnet, dass** eine Abschätzung der Effizienz der Leistungsverstärkung (PAE) in Abhängigkeit von Arbeitspunkten (A) für die maximierte Effizienz der Leistungsverstärkung (PAE) entlang eines Bereichs (B) der Lastlinie (G) und einer Lastlinie (G) bezüglich der Ausdehnung des zusammenhängenden Bereiches (B) sowie der Lage des Arbeitspunktes (A) erfolgt gemäß der Vorschrift

- Wahl eines ersten Randpunktes (P2a) für den das Quadrat der Differenz zwischen einem Strom in dem zweiten Arbeitspunkt (A) und einem Strom in einem der Punkte des zusammenhängenden Bereiches (B) mit größerem Strom als dem Strom im zweiten Arbeitspunkt (A) maximiert ist,

- Wahl eines zweiten Randpunktes (P2b) für den das Quadrat der Differenz zwischen dem Strom im zweiten Arbeitspunkt (A) und dem Strom in einem der Punkte des zusammenhängenden Bereiches (B) mit kleinerem Strom als dem Strom im zweiten Arbeitspunkt (A) maximiert ist, sowie

- Abschätzung der Effizienz der Leistungsverstärkung (PAE) unter Berücksichtigung der Ausdehnung des zusammenhängenden Bereiches (B) sowie der Lage des zweiten Arbeitspunktes (A) als die Hälfte des Absolutwertes des Produktes aus erstens dem Quotienten aus der Differenz und der Summe der Spannungswerte an den beiden Randpunkten (P2a und P2b), und zweitens dem Quotienten aus der Differenz und der Summe der Stromwerte an den beiden Randpunkten (P2a und P2b) .

18. Verfahren zumindest nach Anspruch 11, **dadurch gekennzeichnet, dass** weitere - den ermittelten Arbeitspunkten (A) für die näherungsweise maximierte Effizienz der Leistungsverstärkung (PAE) innerhalb der jeweiligen Bereiche (B) sowie den abgeschätzten Paaren aus Quell- und Lastimpedanzen für die näherungsweise maximierten Effizienzen der Leistungsverstärkung (PAE) in den dergestalt abgeschätzten Arbeitspunkten (A) - zugehörige Werte bestimmt werden.

19. Verfahren nach einem der vorhergehenden Ansprüche, **dadurch gekennzeichnet, dass** die Vielzahl (Gnm) von Lastlinien (G) zu Arbeitspunkten, in welchen Arbeitspunkten das aktive Bauelement oder der Verstärkerschaltkreis bei einer betrachteten Frequenz unbedingt stabil ist, gewählt werden gemäß der Vorschrift:

- Wahl einer dritten Anzahl, sowie einer unteren und einer oberen Schwelle,
- Bestimmung eines bei den die Leistungsverstärkung maximierenden Last- und Quellimpedanzen wirksamen ohmschen Anteils des effektiven Ausgangswiderstandes als Absolutquadrat der die Leistungsverstärkung maximierenden Lastimpedanz, geteilt durch den doppelten Realteil der die Leistungsverstärkung maximierenden Lastimpedanz,
- Unterteilung des Bereiches vom Produkt aus unterer Schwelle und wirksamem ohmschen Anteils des effektiven Ausgangswiderstands bis zum Produkt aus oberer Schwelle und wirksamen ohmschen Anteil des effektiven Ausgangswiderstands in eine dritte Anzahl von Widerstandswerten,

- zu jedem Widerstandswert aus der dritten Anzahl von Widerstandswerten Bestimmung eines Lastreflektionsfaktors und eines Quellreflektionsfaktors, welche erfüllen, dass der Quellreflektionsfaktor das komplex Konjugierte des effektiven Eingangsreflektionsfaktors ist und dass eine Parallelschaltung des zu dem Lastreflektionsfaktor gehörigen Lastwiderstandes mit dem Ausgangswiderstand des betrachteten aktiven Bauelementes oder Schaltkreises einen rein ohmschen Widerstand von der Größe des Widerstandswertes ergibt, sofern zu diesem Widerstandswert ein solches Paar aus Lastreflektionsfaktor und Quellreflektionsfaktor existiert,
- Wahl der Vielzahl (Gnm) von Lastlinien (G) als die Menge ohmscher Lastlinien (G) durch den Arbeitspunkt in Abhängigkeit von denjenigen effektiven Widerstandswerten aus der dritten Anzahl von Widerstandswerten, zu welchen derartige Lastreflektionsfaktoren und Quellreflektionsfaktoren existieren.

20. Elektronische Datenverarbeitungsanlage mit einer Anzeigevorrichtung zur grafische Darstellung, die ausgebildet und eingerichtet ist, ein Verfahren nach einem der vorhergehenden Ansprüche auszuführen.

**Claims**

1. Computer-implemented method for design of a circuit with an active component, which is set to a working point by components of the circuit, in that

- a plurality (Gnm) of load lines (G) of the active component is determined approximately,
- a course of a low-level signal characteristic value along each load line (G) is determined approximately, wherein the low-level signal characteristic value is an amplification or an S parameter or a noise factor or an effective input reflection factor or an effective output reflection factor or an effective output resistance or a Rollet's stability factor,
- a region (B) of each load line (G) is determined as a sub-amount of the load line (G), wherein the region (B) is distinguished by a characteristic property dependent on the low-level signal characteristic value, and
- for determination of the working point of the active component for an optimal coarse signal characteristic value a value, which is associated with the load line (G), of a coarse signal characteristic value is approximately determined from the course of the low-level signal characteristic value within the region (B), wherein the coarse signal characteristic value is a power amplification or an intermodulation product of the order n or a harmonic distortion of nth order or a distortion factor or an efficiency of the power amplification or a noise factor or a compression point or a compression power or a compression of the power amplification or an average of the low-level signal characteristic value or an integral of the lower-level signal characteristic value.

2. Method according to claim 1, **characterised in that** the region (B) of each load line (G) is determined in dependence on a significant value.

3. Method according to claim 2, **characterised in that that** sub-amount of the load line (G) in which the value of the low-level signal characteristic value deviates from a local extreme by no more than a defined factor is determined as region (B).

4. Method according to any one of the preceding claims, **characterised in that** a working point (A) within the region (B) is determined and the determined value of the coarse signal characteristic value is associated with the determined working point (A).

5. Method according to any one of the preceding claims, **characterised in that** for determination of the plurality (Gnm) of load lines (G) a first amount, containing a first number of support working points, is selected and a second amount, containing a second number of load lines, is associated with each support working point.

6. Method according to claim 5, **characterised in that** for determining the plurality (Gnm) of load lines (G)

   - at each support working point an effective output impedence with respect to a given assimilation condition at the input is ascertained and/or
   - at each support working point a straight line gradient is determined as well as a load line (G) as a straight line with the determined straight line gradient through the support working point is selected and
   - the complex conjugate of the effective output impedance is associated with each load line (G) as load impedance.

7. Method according to any one of the preceding claims, **characterised in that** the plurality (Gnm) of load lines (G) is determined, **in that**

   - a first amount of support working points is determined,
   - at each support working point an effective output impedence with respect to a given assimilation condition at the input is determined,

   - at each support working point a straight line gradient is determined as an absolute square of the effective output impedance, divided by twice the real part of the effective output impedance,
   - at each support working point a varied straight line gradient is determined **in that** with self-consistency a load impedance is determined in the manner that a parallel circuit consisting of

      - firstly the effective output impedance of the active component at the support working point for a given assimilation condition at the input of the active component and
      - secondly the load impendance

   has a real value equal to the varied straight line gradient,
   - a load line as straight line with the varied straight line gradient through the support working point is selected and
   - the load impedance determined self-consistently is associated with each load line (G) as output impedance.

8. Method according to claim 7, **characterised in that** the variation of the straight line gradient is effected in such a manner that as varied straight line gradient there is selection of that straight line gradient in which the region (B) has the greatest extent.

9. Method according to any one of the preceding claims, **characterised in that** the low-level signal characteristic value is the power amplification resulting along the load line (G), wherein input and/or output impedances at the support working point fulfil at least one of the conditions:

   - the attainable power amplification is maximised for the input and/or output impedances,
   - the stable attainable power amplification is maximised for the input and/or output impedances,
   - the attainable power amplification in the case of reflection freedom at the input is maximised for the input and/or output impedances,
   - the stable attainable power amplification in the case of reflection freedom at the input is maximised for the input and/or output impedances.
   - the attainable power amplification with minimisation of the noise factor is maximised for the input and/or output impedances,
   - the stable attainable power amplification with minimisation of the noise factor is maximised for input and/or output impedances.

10. Method according to any one of the preceding claims, **characterised in that** at least one determined value of the coarse signal characteristic value is graphically represented over the voltage and the current at the associated working point (A) in the form of contours of the determined values of the coarse signal characteristic value with respect to the working point (A).

11. Method according to any one of the preceding claims, **characterised in that** a pair of source and load impedances is determined, wherein in the determination approximately the efficiency of the load amplification is optimised for an approximately determined working point (A).

12. Method according to at least claim 5, **characterised in that** the first amount of support working points is formed according to the rule:

- selection of a first number,
- selection of a first point,
- selection of a second point in the output characteristic curve field of the relevant component or amplifier circuit,
- selection of a path between the first point and the second point in the output characteristic curve field,
- subdivision of the path into a first number or first points and
- selection of the totality of the first points as first amount of support working points.

13. Method according to claim 12, **characterised in that** the second amount of load impedances is formed according to the rule:

- selection of a second number,
- selection of a second number of load reflection factors,
- determination of the load impedance belonging to a load reflection factor from the second number of load reflection factors and
- selection of the totality of the second number of the load impedances, which belong to one of the load reflection factors, as second amount of load impedances.

14. Method according to claim 13, **characterised in that** the selection of the amount of resistive load lines (G) through the working point is carried out

- with respect to the resistive component of any one from the second number of load reflection factors and
- with respect to an input impedance appropriate for the given working point and the given load impedance.

15. Method according to any one of the preceding claims, **characterised by**

- a selection of an input impedance, which is appropriate for the relevant load impedance and the relevant working point, as that input impedance corresponding with a source reflection factor which represents the complex conjugate of the input reflection factor seen for the relevant load impedance and relevant working point at the input of the active component or amplifier circuit and/or
- a selection of an input impedance, which is appropriate for the relevant load impedance and the relevant working point, as that input impedance corresponding with a source reflection factor which is equal to the input reflection factor seen for the relevant mode impedance and the relevant working point at the input of the active component or amplifier circuit and/or
- a selection of an input impedance, which is appropriate for the relevant load impedance and the relevant working point, as that input impedance at which the noise factor of the active component or amplifier circuit is minimised.

16. Method according to any one of the preceding claims, **characterised by** a selection of the second number (N2) of load reflection factors in such a manner that a load reflection factor (Rn) with an ordinal number (n) as the product of

- firstly the square root of the quotients of the ordinal number (n) and the second number (N2) and
- secondly the square root, which is exponentialised with respect to the basis of Euler's factor e, of the negative of the product of four times pi n with the ordinal number (n),
- is selected for each natural number smaller than the second number (N2) or equal to the second number (N2) as ordinal number.

17. Method according to any one of the preceding claims, **characterised in that** an estimation of the efficiency of the power amplification (PAE) is carried out in dependence on working points (A) for the maximised efficiency of the power amplification (PAE) along a region (B) of the load line (G) and of a load line (G) with respect to the extent of the connected region (B) as well as the position of the working point (A) according to the rule:

- selection of a first edge point (P2a) for which the square of the difference between a current at the second working point (A) and a current at one of the points of the connected region (B) with higher current than the current at the second working point (A) is maximised,
- selection of a second edge point (P2b) for which the square of the difference between a current at the second working point (A) and the current at one of the points of the connected region (B) with lower current than the current at the second working point (A) is maximised and

- estimation of the efficiency of the power amplification (PAE) with consideration of the extent of the connected region (B) as well as the position of the second working point (A) as half of the absolute value of the product of firstly the quotient of the difference and the sum of the voltage values at the two edge points (P2a and P2b) and secondly the quotient of the difference and the sum of the current values at the two edge points (P2a and P2b).

18. Method according to at least claim 11, **characterised in that** further values belonging to the determined working points (A) for the approximately maximised efficiency of the power amplification (PAE) within the respective regions (B) as well as the estimated pairs of source and load impedances for the approximately maximised efficiencies of the performance amplification (PAE) at the work points (A) estimated **in that** manner are determined.

19. Method according to any one of the preceding claims, **characterised in that** the plurality (Gnm) of load lines (G) to working points, at which working points the active component or the amplifier circuit is unconditionally stable for a relevant frequency, are selected according to the rule:

- selection of a third number, as well as a lower and an upper threshold,
- determination of a resistive component, which is effective at the load and source impedances maximising the power amplification, of the effective output resistance as an absolute square of the load impedance maximising the power amplification, divided by twice the real part of the load impedance maximising the power amplification,
- subdivision of the region by the product of lower threshold and effective resistive component of the effective output resistance up to the product of upper threshold and effective resistive component of the effective output resistance into a third number of resistance values,
- determination, for each resistance value of the third number of resistance values, of a load reflection factor and a source reflection factor which fulfil the source reflection factor being the complex conjugate of the effective input reflection factor and a parallel circuit of the load resistance, which belongs to the load reflection factor, together with the output resistance of the relevant effective component or circuit giving a purely resistive resistance of the magnitude of the resistance value insofar as such a pair of load reflection factor and source reflection factor exists at this resistance value,

- selection of the plurality (Gnm) of load lines (G) as the amount of resistive load lines (G) through the working point in dependence on those effective resistance values of the third number of resistance values at which load reflection factors and source reflection factors of that kind exist.

20. Electronic data processing plant with a display device for graphical representation, which is constructed and equipped to execute a method according to any one of the preceding claims.

**Revendications**

1. Procédé mis en oeuvre par un ordinateur pour la conception d'un circuit avec un composant actif qui est réglé par des composants du circuit en un point de fonctionnement, consistant dans le fait que

- l'on détermine par approximation une pluralité (Gnm) de lignes de charge (G) du composant actif,
- l'on définit par approximation le développement d'une caractéristique de bas signal le long de chacune des lignes de charge (G), la caractéristique de bas signal étant une amplification ou un paramètre S ou un facteur de bruit ou un facteur effectif de réflexion d'entrée ou un facteur effectif de réflexion de sortie ou une résistance effective de sortie ou un facteur de stabilité de Rollet.
- l'on définit une zone (B) de chacune des lignes de charge (G) comme une quantité partielle de la ligne de charge (G), la zone (B) étant distinguée par une propriété caractéristique fonction de la caractéristique de bas signal, et
- pour définir le point de fonctionnement du composant actif pour une caractéristique optimale de grand signal, on détermine par approximation une valeur d'une caractéristique de grand signal affectée à la ligne de charge (G) à partir du développement de la caractéristique de bas signal à l'intérieur de la zone (B), la caractéristique de grand signal étant une amplification de puissance ou un produit d'intermodulation d'ordre n ou une distorsion harmonique d'ordre n ou un facteur de distorsion ou une efficience de l'amplification de puissance ou un facteur de bruit ou un point de compression ou une puissance de compression ou une compression de l'amplification de puissance ou une moyenne de la caractéristique de bas signal ou une intégrale de la caractéristique de bas signal.

**2.** Procédé selon la revendication 1, **caractérisé en ce que** la zone (B) de chacune des lignes de charge (G) est déterminée en fonction d'une valeur significative.

**3.** Procédé selon la revendication 2, **caractérisé en ce que** l'on définit comme zone (B) la quantité partielle de la ligne de charge (G) dans laquelle la valeur de la caractéristique de bas signal ne diffère pas de plus d'un facteur donné d'une valeur extrême locale.

**4.** Procédé selon l'une quelconque des revendications précédentes, **caractérisé en ce que** l'on détermine un point de fonctionnement (A) à l'intérieur de la zone (B) et **en ce que** la valeur déterminée de la caractéristique de grand signal est affectée au point de fonctionnement (A) déterminé.

**5.** Procédé selon l'une quelconque des revendications précédentes, **caractérisé en ce que**, pour déterminer la pluralité (Gnm) de lignes de charge (G), on choisit une première quantité contenant un premier nombre de points de fonctionnement auxiliaires, et **en ce qu'**on affecte à chaque point de fonctionnement auxiliaire une deuxième quantité comprenant un deuxième nombre de points de fonctionnement.

**6.** Procédé selon la revendication 5, **caractérisé en ce que,** pour déterminer la pluralité (Gnm) de lignes de charge (G),

   - on détermine dans chaque point de fonctionnement auxiliaire, à l'entrée, une impédance effective de sortie pour une condition d'adaptation donnée, et/ou
   - on détermine dans chaque point de fonctionnement auxiliaire une inclinaison de droite, de même qu'une ligne de charge (G) est choisie comme droite avec l'inclinaison déterminée par le point de fonctionnement auxiliaire, et
   - on affecte à chaque ligne de charge (G) comme impédance de charge le nombre complexe conjugué de l'impédance effective de sortie.

**7.** Procédé selon l'une quelconque des revendications précédentes, **caractérisé en ce que** la détermination de la pluralité (Gnm) de lignes de charge (G) consiste **en ce que** :

   - l'on détermine une première quantité de points de fonctionnement auxiliaires,
   - l'on détermine à l'entrée dans chaque point de fonctionnement auxiliaire une impédance effective de sortie pour une condition d'adaptation donnée,
   - l'on détermine dans chaque point de fonctionnement auxiliaire une inclinaison de droite correspondant au carré absolu de l'impédance effective de sortie, divisé par deux fois la partie réelle de l'impédance de sortie effective,
   - l'on détermine dans chaque point de fonctionnement auxiliaire une inclinaison variable de droite, en déterminant de manière autoconsistante une impédance de charge de telle façon qu'un circuit en parallèle, consistant :

      - premièrement, en l'impédance effective de sortie du composant actif au point de fonctionnement auxiliaire pour une condition d'adaptation donnée à l'entrée du composant actif, ainsi que
      - deuxièmement, en l'impédance de charge,

présente une valeur réelle égale à l'inclinaison variable de droite,
   - de même que le point de fonctionnement d'appui choisit une ligne de charge comme droite à inclinaison de droite variable, et
   - l'on affecte à chaque ligne de charge (G) l'impédance de charge déterminée de manière autoconsistante comme impédance de sortie.

**8.** Procédé selon la revendication 7, **caractérisé en ce que** la variation de l'inclinaison de droite s'effectue de telle manière que l'on choisit comme inclinaison variable de droite l'inclinaison de droite pour laquelle la zone (B) est la plus étendue.

**9.** Procédé selon l'une quelconque des revendications précédentes, **caractérisé en ce que** la caractéristique de signal bas est l'amplification de puissance se dégageant le long de la ligne de charge (G), l'impédance d'entrée et/ou de sortie au point de fonctionnement auxiliaire remplissant l'une au moins des conditions suivantes :

   - pour l'impédance d'entrée et/ou de sortie, l'amplification de puissance pouvant être atteinte est maximisée,
   - pour l'impédance d'entrée et/ou de sortie, l'amplification de puissance pouvant être atteinte de manière stable est maximisée,
   - pour l'impédance d'entrée et/ou de sortie, l'amplification de puissance pouvant être atteinte de manière stable en cas de liberté de réflexion à l'entrée est maximisée,
   - pour l'impédance d'entrée et/ou de sortie, l'amplification de puissance pouvant être atteinte en cas de liberté de réflexion à l'entrée est maximisée,
   - pour l'impédance d'entrée et/ou de sortie, l'amplification de puissance pouvant être atteinte en minimisant le facteur de bruit est maximisée,
   - pour l'impédance d'entrée et/ou de sortie, l'amplification de puissance pouvant être atteinte de manière stable en minimisant le facteur de bruit est maximisée.

**10.** Procédé selon l'une quelconque des revendications précédentes, **caractérisé en ce que** l'on représente graphiquement, sous la forme d'isophypses des valeurs déterminées de la caractéristique de grand signal par rapport aux points de fonctionnement (A), au moins une valeur déterminée de la caractéristique de grand signal par rapport à la tension et au courant au point de fonctionnement (A) associé.

**11.** Procédé selon l'une quelconque des revendications précédentes, **caractérisé en ce que** l'on détermine une paire impédance source et impédance de charge, l'efficience de l'amplification de puissance pour un point de fonctionnement (A) déterminé par approximation étant, lors de la détermination, optimisée par appoximation.

**12.** Procédé selon au moins la revendication 5, **caractérisé en ce que** la première quantité de points de fonctionnement auxiliaires est constituée selon la spécification suivante :

- sélection d'un premier nombre,
- sélection d'un premier point,
- sélection d'un deuxième point dans le champ des caractéristiques de sortie du composant considéré ou du circuit d'amplification,
- sélection d'une distance entre le premier point et le deuxième point dans le champ de caractéristiques de sortie,
- subdivision de la distance en un premier nombre de premiers points, et
- sélection de l'ensemble des premiers points comme première quantité de points de fonctionnement auxiliaires.

**13.** Procédé selon la revendication 12, **caractérisé en ce que** la deuxième quantité d'impédances de charge est constituée selon la spécification suivante :

- sélection d'un deuxième nombre,
- sélection d'un deuxième nombre de facteurs de réflexion de charge,
- détermination de l'impédance de charge associée à un facteur de réflexion de charge parmi le deuxième nombre de facteurs de réflexion de charge, et
- sélection de la totalité du deuxième nombre d'impédances de charge affectées à l'un des facteurs de réflexion de charge comme deuxième quantité d'impédances de charge.

**14.** Procédé selon la revendication 13, **caractérisé en ce que** la sélection de la quantité de lignes de charge ohmiques (G) est effectuée par le point de fonctionnement

- en ce qui concerne la partie ohmique d'une impédance d'entrée quelconque parmi le deuxième nombre de facteurs de réflexion de charge, de même que
- en ce qui concerne une impédance d'entrée utile pour le point de fonctionnement donné et l'impédance de charge donnée.

**15.** Procédé selon l'une quelconque des revendications précédentes, **caractérisé par** :

- la sélection, pour l'impédance de charge et le point de fonctionnement considérés, d'une impédance d'entrée utile comme l'impédance d'entrée correspondant à un facteur de réflexion source, qui représente le nombre complexe conjugué du facteur de réflexion d'entrée existant pour l'impédance de charge et le point de fonctionnement considérés à l'entrée du composant actif ou du circuit d'amplification,
- la sélection, pour l'impédance de charge et le point de fonctionnement considérés, d'une impédance d'entrée utile comme l'impédance d'entrée correspondant à un facteur de réflexion source, qui est égal au facteur de réflexion d'entrée existant pour l'impédance de charge et le point de fonctionnement considérés à l'entrée du composant actif ou du circuit d'amplification, et/ou
- la sélection d'une impédance d'entrée utile pour l'impédance de charge et le point de fonctionnement considérés comme l'impédance d'entrée pour laquelle le facteur de bruit du composant actif ou du circuit d'amplification est minimisé.

**16.** Procédé selon l'une quelconque des revendications précédentes, **caractérisé par** la sélection d'un deuxième nombre (N2) de facteurs de réflexion de charge de telle manière que l'on choisit un facteur de réflexion de charge (Rn) dont le numéro d'ordre (n) est le produit

- premièrement de la racine du quotient du numéro d'ordre (n) et du deuxième nombre (N2), et
- de la racine exponentielle en base du chiffre d'Euler "e" à partir du négatif du produit de la multiplication de quatre fois le nombre $\pi$ par le numéro d'ordre (n),
- pour chaque nombre naturel inférieur au deuxième nombre (N2) ou égal au deuxième nombre (N2) comme numéro d'ordre.

**17.** Procédé selon l'une quelconque des revendications précédentes, **caractérisé en ce qu'**une évaluation de l'efficience de l'amplification de puissance (PAE) en fonction de points de fonctionnement (A) pour l'efficience maximisée de l'amplification de puissance (PAE) le long d'une zone (B) de la ligne de charge (G) et d'une ligne de charge (G) concernant l'extension de la zone (B) connexe ainsi que la situation du point de fonctionnement (A) s'effectue selon la spécification suivante :

- sélection d'un premier point marginal (P2a) pour lequel le carré de la différence entre un courant dans le deuxième point de fonctionnement (A) et un courant dans un des points de la zone connexe (B) est maximisé avec un courant supérieur au courant dans le deuxième point de fonctionnement (A),
- sélection d'un deuxième point marginal (P2b) pour lequel le carré de la différence entre le courant dans le deuxième point de fonctionnement (A) et le courant dans un des points de la zone connexe (B) est maximisé avec un courant inférieur au courant dans le deuxième point de fonctionnement (A), ainsi que
- évaluation de l'efficience de l'amplification de puissance (PAE) en tenant compte de l'extension de la zone (B) connexe ainsi que de la situation du deuxième point de fonctionnement (A) comme étant la moitié de la valeur absolue du produit résultant premièrement du quotient de la différence et de la somme des valeurs de tension aux deux points marginaux (P2a et P2b) et deuxièmement du quotient de la différence et de la somme des valeurs de courant aux deux points marginaux (P2a et P2b).

**18.** Procédé selon au moins la revendication 11, **caractérisé en ce que** l'on détermine d'autres valeurs intrinsèques aux points de fonctionnement (A) déterminés pour l'efficience maximisée par approximation de l'amplification de puissance (PAE) à l'intérieur de chacune des zones (B) ainsi qu'intrinsèques aux paires évaluées d'impédances source et d'impédances de charge pour l'efficience maximisée par approximation de l'amplification de puissance (PAE) aux points de fonctionnement (A) ainsi évalués.

**19.** Procédé selon l'une quelconque des revendications précédentes, **caractérisé en ce que** la pluralité (Gnm) de lignes de charge (G) sont choisies comme points de fonctionnement, points de fonctionnement dans lesquels le composant actif ou le circuit d'amplification est impérativement stable pour une fréquence considérée, selon la spécification suivante :

- sélection d'un troisième nombre, ainsi que d'un seuil inférieur et d'un seuil supérieur,
- détermination d'une composante ohmique de la résistance effective de sortie, active pour les impédances de charge et source maximisant l'amplification de puissance, comme carré absolu de l'impédance de charge maximisant l'amplification de puissance, divisé par le double de la partie réelle de l'impédance de charge maximisant l'amplification de puissance,
- subdivision de la zone du produit du seuil inférieur et de composantes ohmiques actives de la résistance effective de sortie jusqu'au produit du seuil et de composantes ohmiques actives de la résistance effective de sortie en un troisième nombre de valeurs de résistance,
- pour chaque valeur de résistance du troisième nombre de valeurs de résistances, détermination d'un facteur de réflexion de charge et d'un facteur de réflexion source, qui font que le facteur de réflexion source est le nombre complexe conjugué du facteur effectif de réflexion d'entrée, et qu'un montage en parallèle de la résistance de charge associée au facteur de réflexion de charge avec la résistance de sortie de l'élément actif ou du circuit considéré donne une pure résistance ohmique de la taille de la valeur de résistance, dans la mesure où existe pour cette valeur de résistance une paire constituée d'un facteur de réflexion de charge et d'un facteur de réflexion source,
- sélection par le point de fonctionnement de la pluralité (Gnm) de lignes de charge (G) comme la quantité de lignes de charge (G) ohmiques en fonction des valeurs de résistance effectives parmi le troisième nombre de valeurs de résistance pour lesquelles existent de tels facteurs de réflexion de charge et de tels facteurs de réflexion source.

**20.** Dispositif de traitement de données électronique comprenant un dispositif d'affichage pour la représentation graphique, conformée et installée pour réaliser un procédé selon l'une quelconque des revendications précédentes,

FIG.1a

FIG.1b

FIG.1c

FIG.2a

28

FIG.2b

FIG.2c

PAE

0.3

0.2

0.1

0 0.1 0.2

ICC [A]

FIG. 2d

1

0.5

Jm(T$_L$) 0

-0.5

-1

-1 -0.5 0 0.5 1

R$_e$(T$_L$)

FIG. 3a

FIG. 3b

FIG. 4

**EP 1 713 014 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5528509 A